# EUROPEAN PATENT APPLICATION

(11) **EP 4 629 770 A1**
(43) Date of publication of application: **08.10.2025**
(21) Application number: 25164735.0
(22) Date of filing: 19.03.2025
(51) Int. Cl.: H10B 12/00

(54) **SEMICONDUCTOR DEVICES HAVING PERIPHERAL CIRCUIT REGIONS**

(30) Priority: 02.04.2024 KR 20240044811
(71) Applicant: Samsung Electronics Co., Ltd., Suwon-si, Gyeonggi-do 16677 (KR)
(72) Inventor: KIM, Jungun, 16677 Suwon-si (KR); KWAK, Chaeseok, 16677 Suwon-si (KR); CHANG, Jihoon, 16677 Suwon-si (KR); CHO, Seongwon, 16677 Suwon-si (KR); PARK, Youngkwan, 16677 Suwon-si (KR)
(74) Representative: Marks & Clerk LLP

(57) **Abstract**

A semiconductor device according to an example embodiment of the present disclosure includes a memory cell array region including memory cells, each of the memory cells including a cell transistor and an information storage structure, and a peripheral circuit region spaced apart from the memory cell array region in a horizontal direction. The peripheral circuit region includes an upper interconnection disposed on a first vertical level, a lower interconnection disposed on a second vertical level different from the first vertical level and at least one peripheral transistor between the first vertical level and the second vertical level, where the at least one peripheral transistor includes a channel structure extending in the vertical direction.

## Description

### FIELD OF THE INVENTION

The present disclosure relates to semiconductor devices having peripheral circuit regions.

### BACKGROUND OF THE INVENTION

With an increase in demand for high performance, speed, and/or multifunctionalization of a semiconductor device, the degree of integration of a semiconductor device has increased. In manufacturing a semiconductor device having a fine pattern corresponding to the tendency for high integration of a semiconductor device, it may be necessary to implement patterns having a fine width or a fine separation distance.

### SUMMARY

An aspect of the present disclosure is to provide a semiconductor device having a peripheral circuit region in which peripheral transistors, having a channel structure extending in a vertical direction, are disposed.

A semiconductor device according to one or more example embodiments may include: a memory cell array region including memory cells, each of the memory cells including a cell transistor and an information storage structure; and a peripheral circuit region spaced apart from the memory cell array region in a horizontal direction, wherein the peripheral circuit region may include: an upper interconnection disposed on a first vertical level; a lower interconnection disposed on a second vertical level different from the first vertical level; and at least one peripheral transistor between the first vertical level and the second vertical level, and the at least one peripheral transistor may include a channel structure extending in a vertical direction.

A semiconductor device according to one or more example embodiments may include: a first structure including a memory cell array region and a first peripheral circuit region spaced apart from the memory cell array region in a horizontal direction, wherein the memory cell array region may include: a bit line structure; cell channel structures disposed on the bit line structure and extending in a vertical direction; word lines between the cell channel structures; contact patterns disposed on the cell channel structures and electrically connected to the cell channel structures; and an information storage structure on the contact patterns. The first peripheral circuit region may include: an upper interconnection disposed on a first level; a lower interconnection disposed on a second level, different from the first level; and at least one first peripheral transistor between the first level and the second level. The at least one first peripheral transistor may include a peripheral channel structure extending in the vertical direction. At least a portion of the upper interconnection may be disposed on the same level as the bit line structure.

A semiconductor device according to one or more example embodiments may include: a memory cell array region including memory cells, each of the memory cells including a cell transistor and an information storage structure; and a peripheral circuit region spaced apart from the memory cell array region in a horizontal direction. The peripheral circuit region may include: a first upper interconnection extending in a first horizontal direction and disposed on a first doped region; and a second upper interconnection extending in the first horizontal direction and disposed on a second doped region. The peripheral circuit region may include a first lower interconnection disposed below the first upper interconnection; and a second lower interconnection disposed below the second upper interconnection. The peripheral circuit region may include a first channel structure extending between the first upper interconnection and the first lower interconnection in the vertical direction; and a second channel structure extending between the second upper interconnection and the second lower interconnection in a vertical direction. The peripheral circuit may include a peripheral gate electrode disposed on side surfaces of the first channel structure and the second channel structure and extending in a second horizontal direction, intersecting the first horizontal direction. The peripheral circuit may include an interconnection line electrically connected to the first lower interconnection and the second lower interconnection. The first upper interconnection and the second upper interconnection may be disposed on a first level, and the first lower interconnection and the second lower interconnection may be disposed on a second level. The interconnection line may be disposed on a third level, different from the first level and the second level.

According to one or more example embodiments of the present disclosure, a first peripheral circuit region may be disposed on the same level as a memory cell region and may be disposed on a second peripheral circuit region. Accordingly, the size of the semiconductor device may be reduced by an area of the first peripheral circuit region. Additionally, in one or more embodiments, since the peripheral transistor in the first peripheral circuit region may have a structure similar to that of the cell transistor in the memory cell region, the first peripheral circuit region may be formed without excessively adding fabrication process(es).

Advantages and effects of the present application are not limited to the foregoing content and may be more easily understood in describing specific example embodiments of the present disclosure.

At least some of the above and other features of the invention are set out in the claims.

### BRIEF DESCRIPTION OF DRAWINGS

The above and other aspects, features, and advantages of the present disclosure will be more clearly understood from the following detailed description, taken in conjunction with the accompanying drawings, in which:
FIG. 1 is a schematic perspective view of a semiconductor device according to an example embodiment;
FIG. 2 is a plan view of a semiconductor device according to an example embodiment;
FIG. 3A is a vertical cross-sectional view taken along line I-I' of the semiconductor device illustrated in FIG. 2;
FIG. 3B is a partially enlarged view of the semiconductor device illustrated in FIG. 3A;
FIG. 4 is a circuit diagram of a peripheral circuit element of a first peripheral circuit region according to an example embodiment;
FIG. 5 is a plan view of a peripheral circuit element of a first peripheral circuit region according to an example embodiment;
FIG. 6 is a schematic perspective view of a peripheral circuit element illustrated in FIG. 5;
FIG. 7A is a vertical cross-sectional view taken along line II-II' of the peripheral circuit element illustrated in FIG. 5;
FIG. 7B is a partially enlarged view of the semiconductor device illustrated in FIG. 7A;
FIG. 8 is a vertical cross-sectional view of a peripheral circuit element of a first peripheral circuit region according to an example embodiment;
FIGS. 9, 10, 11, and 12 are plan views of peripheral circuit elements of a first peripheral circuit region according to an example embodiment;
FIG. 13 is a circuit diagram of a peripheral circuit element of a first peripheral circuit region according to an example embodiment;
FIG. 14 is a plan view of a peripheral circuit element of a first peripheral circuit region according to an example embodiment;
FIG. 15 is a schematic perspective view of a peripheral circuit element illustrated in FIG. 14;
FIG. 16 is a plan view of a peripheral circuit element of a first peripheral circuit region according to an example embodiment;
FIG. 17 is a schematic perspective view of a peripheral circuit element illustrated in FIG. 16;
FIG. 18 is a circuit diagram of a peripheral circuit element of a first peripheral circuit region according to an example embodiment;
FIGS. 19 and 20 are schematic perspective views of peripheral circuit elements in a first peripheral circuit region according to an example embodiment;
FIG. 21 is a circuit diagram of a peripheral circuit element of a first peripheral circuit region according to an example embodiment;
FIG. 22 is a plan view of a peripheral circuit element of a first peripheral circuit region according to an example embodiment;
FIG. 23 is a schematic perspective view of a peripheral circuit element illustrated in FIG. 22;
FIG. 24 is a plan view of a peripheral circuit element of a first peripheral circuit region according to an example embodiment;
FIG. 25 is a schematic perspective view of a peripheral circuit element illustrated in FIG. 24;
FIG. 26 is a circuit diagram of a peripheral circuit element of a first peripheral circuit region according to an example embodiment;
FIGS. 27 and 28 are schematic perspective views of a peripheral circuit element in a first peripheral circuit region according to an example embodiment;
FIG. 29 is a circuit diagram of a peripheral circuit element of a first peripheral circuit region according to an example embodiment;
FIG. 30 is a schematic perspective view of a peripheral circuit element of a first peripheral circuit region according to an example embodiment; and
FIG. 31 is a plan view of a peripheral circuit element of a first peripheral circuit region according to an example embodiment.

### DETAILED DESCRIPTION

Hereinafter, example embodiments of the present disclosure will be described with reference to the accompanying drawings. The terms "first," "second," etc., may be used herein merely to distinguish one component, layer, direction, etc. from another. The terms "comprises," "comprising," "includes" and/or "including," when used herein, specify the presence of stated elements, but do not preclude the presence of additional elements. The term "and/or" includes any and all combinations of one or more of the associated listed items. The term "connected" may be used herein to refer to a physical and/or electrical connection. When components or layers are referred to herein as "directly" on, or "in direct contact" or "directly connected," no intervening components or layers are present.

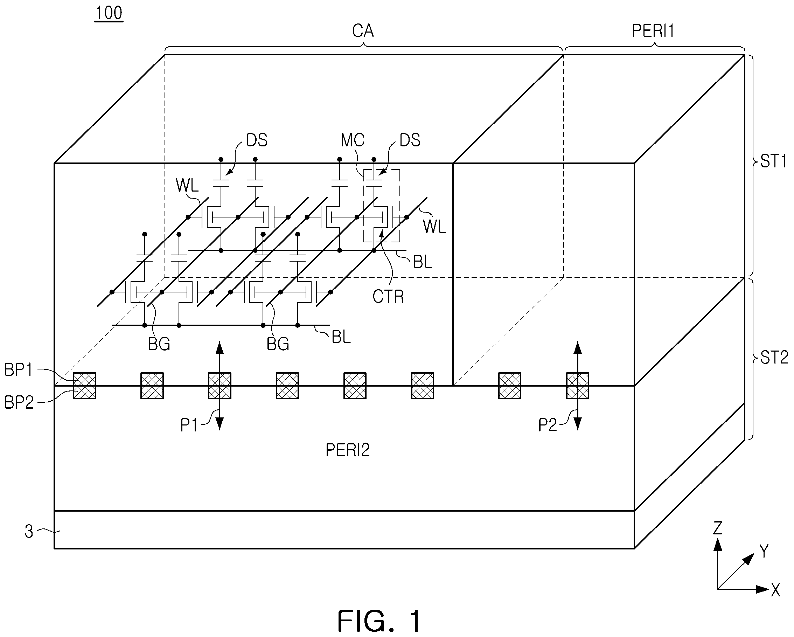

FIG. 1 is a schematic perspective view of a semiconductor device according to an example embodiment.

Referring to FIG. 1, a semiconductor device 100 may include a first structure ST1 and a second structure ST2 below the first structure ST1. The first structure ST1 may include a memory cell array region CA and a first peripheral circuit region PERI1.

The memory cell array region CA may include a memory cell array. In an example embodiment, the memory cell array may include a plurality of bit lines BL, a plurality of word lines WL, a plurality of back gate lines BG, and a plurality of memory cells MC.

Each of the memory cells MC may include a cell transistor CTR and an information storage element DS. One memory cell MC may be disposed between one word line WL and one bit line BL. The cell array of the semiconductor device 100 may correspond to a memory cell array of a Dynamic Random Access Memory (DRAM) device.

The cell transistor CTR may include a gate, a source, and a drain. The gate may be connected to the word line WL, and the source may be connected to the bit line BL, and the drain may be connected to an information storage element DS. The information storage element DS may include a capacitor formed of lower and upper electrodes and a dielectric layer.

The word lines WL may extend in a Y-direction and may be spaced apart from each other in an X-direction. The word lines WL may be disposed on the same level (e.g., in a Z-direction) and may be connected to different memory cells MC. The term "level" may be used herein with reference to spacings along the Z-direction, also referred to herein as a vertical direction. The bit lines BL may extend in the X-direction and may be spaced apart from each other in the Y-direction, also referred to herein as horizontal or lateral directions. A horizontal direction (e.g. the X-direction or the Y-direction) may be a direction parallel to an upper surface of a substrate 3, and a vertical direction (e.g. the Z-direction) may be a direction perpendicular to the upper surface of the substrate 3. In some embodiments, the term "same level" or equivalents may mean the same level or substantially the same level. For example, in some embodiments, the same level may mean an average level of a feature or structure, and the same level may mean within a tolerance value, such as within 10%, 5%, 2%, 1% or 0.5% of the level or average level. The term "different level" or equivalents may be construed using the definition of the same level, or in some examples, may mean that the levels are spaced apart, optionally by a minimum separation, which may be a minimum feature length of the manufacturing process, or may be by e.g. at least 1 nm, or at least 3 nm, or at least 5nm, or at least 10nm, or at least 20nm, or at least 50 nm, or by any suitable minimum level difference.

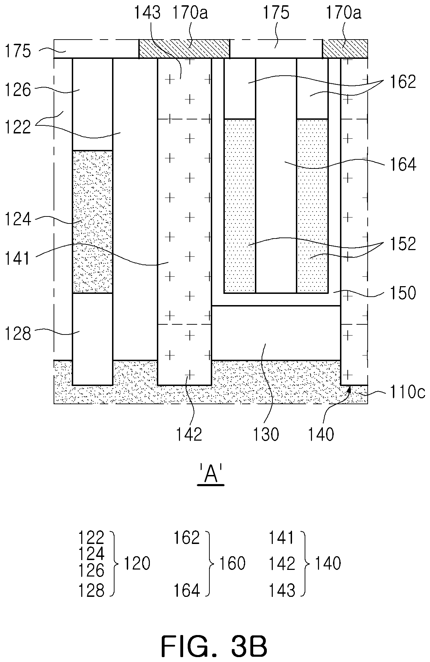

One back gate line BG may be disposed between two adjacent word lines WL. For example, the two adjacent word lines WL may share one back gate line BG. A voltage different from a voltage applied to the word lines WL may be applied to the back gate line BG. Channel regions 141 (see FIG. 3B), which are the channels of the cell transistor CTR, may be a floating body, and the back gate line BG may control the charge accumulated in the channel regions 141 (see FIG. 3B), for example, holes, thereby suppressing or controlling a floating body effect as well as preventing a threshold voltage of the cell transistor CTR from being changed. Accordingly, the back gate line BG may improve the electrical characteristics of the cell transistor CTR.

In an example, the back gate lines BG may be independently and individually controlled by considering the inter-layer characteristic distribution of the memory cell transistors CTR disposed in each layer. Alternatively, at least some of the back gate lines BG may be electrically connected to each other and controlled together.

The first peripheral circuit region PERI1 may be spaced apart from the memory cell array region CA in a horizontal direction (X-direction) and may include peripheral circuit elements including peripheral transistors. For example, in the first peripheral circuit region PERI1, logic elements such as an inverter circuit, a NAND gate circuit, a NOR gate circuit, an AND gate circuit, an OR gate circuit, a XOR gate circuit, a XNOR gate circuit, a NOT gate circuit, an antifuse, and the like, may be disposed.

The second structure ST2 may overlap the first structure ST1 in a vertical direction (Z-direction). The second structure ST2 may include a second peripheral circuit region PERI2 on the substrate 3. The second peripheral circuit region PERI2 may be electrically connected to the memory cell array region CA and the first peripheral circuit region PERI1. The second peripheral circuit region PERI2 may include peripheral circuit elements, and may include, for example, sub-word line drivers electrically connected to the word lines WL and sense amplifiers electrically connected to the bit lines BL.

In an example embodiment, the second structure ST2 may be bonded to the first structure ST1. For example, the first structure ST1 may include first bonding pads BP1 on a lower surface thereof, and the second structure ST2 may include second bonding pads BP2 on an upper surface thereof. The first bonding pads BP1 may be bonded to the second bonding pads BP2, and may electrically connect the first structure ST1 and the second structure ST2. For example, the first bonding pads BP1 and the second bonding pads BP2 may provide a path P1 for electrically connecting the memory cell array region CA and the second peripheral circuit region PERI2. The first bonding pads BP1 and the second bonding pads BP2 may also provide a path P2 for electrically connecting the first peripheral circuit region PERI1 and the second peripheral circuit region PERI2. The second peripheral circuit region PERI2 may include a first region and a second region that overlap the memory cell array region CA and the first peripheral circuit region PERI1 in a vertical direction.

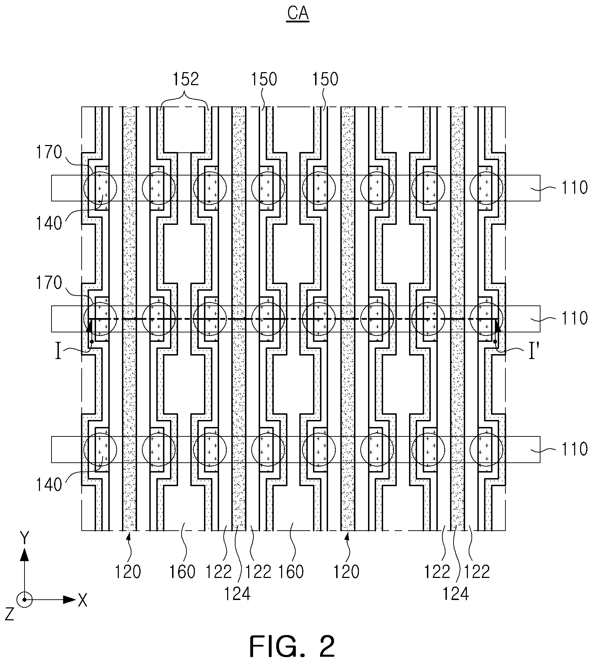

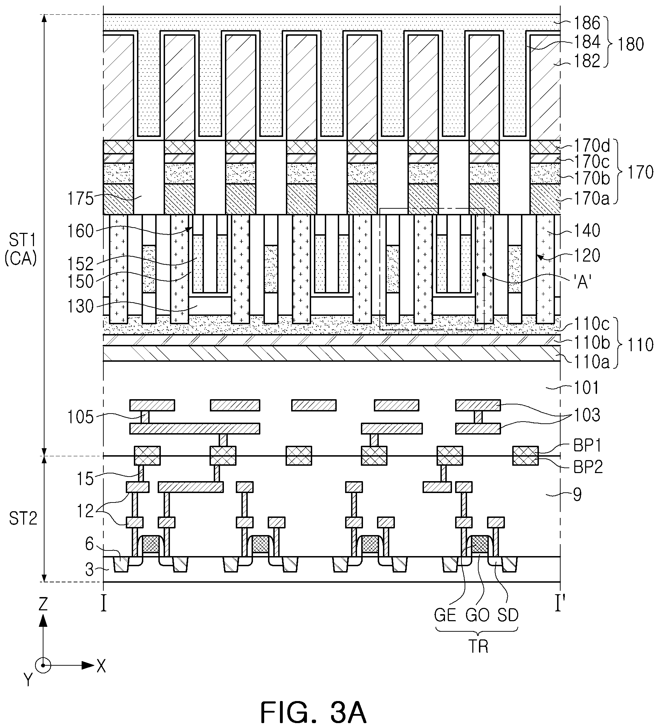

FIG. 2 is a plan view of a semiconductor device according to an example embodiment. FIG. 3A is a vertical cross-sectional view taken along line I-I' of the semiconductor device illustrated in FIG. 2. FIG. 3B is a partially enlarged view of the semiconductor device illustrated in FIG. 3A. According to an example embodiment of the present disclosure, the circuit diagram of the memory cell array of FIG. 1 may be implemented with semiconductor devices described in FIGS. 2 and 3.

Referring to FIGS. 2 to 3B, a memory cell array region CA of a semiconductor device 100 according to an example embodiment of the present disclosure may include a bit line structure 110, a back gate structure 120, a channel structure 140, a word line 152, an insulating structure 160, a contact pattern 170 and an information storage structure 180.

The memory cell array region CA may include a vertical channel transistor comprised of a channel structure 140 and word lines 152 disposed on at least one side of the channel structure 140. The vertical channel transistor may correspond to the cell transistor CTR illustrated in FIG. 1.

The bit line structure 110 may extend in the X-direction. In an example embodiment, the bit line structure 110 may be electrically connected to the channel structure 140. The bit line structure 110 may be provided in plural, and a plurality of bit line structures 110 may be spaced apart from each other in the Y-direction and extend in parallel. The bit line structure 110 may correspond to the bit line BL illustrated in FIG. 1.

The bit line structure 110 may include doped polysilicon, a metal, conductive metal nitride, a metal-semiconductor compound, conductive metal oxide, conductive graphene, carbon nanotubes, or combinations thereof. For example, at least one of the bit line structures 110 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, graphene, carbon nanotubes, or combinations thereof. In an example embodiment, the bit line structure 110 may include a first conductive pattern 110a, a second conductive pattern 110b, and a third conductive pattern 110c, which are sequentially stacked. The first conductive pattern 110a may include a metallic material such as titanium (Ti), tantalum (Ta), tungsten (W), and aluminum (Al), and the second conductive pattern 110b may include, for example, a metal nitride such as titanium nitride (TiN) or a silicide material such as titanium silicide (TiSi), and the third conductive pattern 110c may include a semiconductor material such as polycrystalline silicon. The third conductive pattern 110c may be a layer doped with impurities. However, according to example embodiments, the materials of layers included in the bit line structure 110, the number of layers and thicknesses thereof may be variously changed.

The back gate structures 120 may intersect the bit line structures 110. For example, the back gate structures 120 may extend in the Y-direction and may be spaced apart from each other in the X-direction.

The back gate structure 120 may include a back gate dielectric layer 122, a back gate electrode 124, an upper capping layer 126, and a lower capping layer 128. The back gate electrodes 124 may extend in the Y-direction and may be spaced apart from each other in the X-direction. The back gate electrode 124 may be configured to remove charges trapped within the channel structure 140. The channel structure 140 may be a floating body, and the back gate electrode 124 may be a structure to complement a floating channel structure 140 to prevent or minimize performance degradation of the semiconductor device 100 due to a floating body effect of the channel structure 140. The back gate electrode 124 may correspond to the back gate line BG illustrated in FIG. 1.

The back gate electrode 124 may include doped polysilicon, a metal, conductive metal nitride, a metal-semiconductor compound, conductive metal oxide, graphene, carbon nanotubes, or combinations thereof. For example, the back gate electrode 124 may be formed of doped polysilicon, Al, Cu, Ti, Ta, Ru, W, Mo, Pt, Ni, Co, TiN, TaN, WN, NbN, TiAl, TiAlN, TiAlC, TaAlC, TiSi, TiSiN, TaSi, TaSiN, RuTiN, NiSi, CoSi, IrOx, RuOx, graphene, carbon nanotubes, or combination thereof, but the present disclosure is not limited thereto. The back gate electrode 124 may be formed of a single layer or multiple layers of the above-described materials.

In an example embodiment, the back gate electrode 124 may be formed of the same material as the gate electrode 152, but the present disclosure is not limited thereto, and the back gate electrode 124 may include other materials.

The back gate dielectric layers 122 may extend in the Y-direction along both or opposing side surfaces of the back gate electrodes 135. A vertical length (e.g., along the Z-direction) of the back gate dielectric layer 122 may be greater than a vertical length of the back gate electrode 124. For example, an upper surface of the back gate dielectric layer 122 may be disposed on a level higher than that of an upper surface of the back gate electrode 124, and a lower surface of the back gate dielectric layer 122 may be disposed on a level higher than that of a lower surface of the back gate electrode 124. The lower surface of the back gate dielectric layer 122 may be in contact with the third conductive pattern 110c of the bit line structure 110. Each of the back gate dielectric layers 122 may include at least one of silicon oxide and high-κ dielectric. A high-κ dielectric may be material with a higher dielectric constant than silicon oxide. A low-κ dielectric may have a dielectric constant equal to or lower than silicon oxide.

The memory cell array region CA may further include an upper capping layer 126 and a lower capping layer 128. The upper capping layer 126 may be disposed on the back gate electrode 124. An upper surface of the upper capping layer 126 may be coplanar with the upper surface of the back gate dielectric layer 122. The upper capping layer 126 may include silicon oxide, silicon nitride, silicon oxynitride, silicon carbonitride, low-κ dielectric, or combinations thereof. For example, the upper capping layer 126 may include silicon nitride.

The lower capping layer 128 may be disposed below the back gate electrode 124. A lower surface of the lower capping layer 128 may be disposed on a lower level than a lower surface of the back gate dielectric layer 122.

The channel structure 140 may be disposed on the bit line structure 110, and may extend in the vertical direction (Z-direction). In plan view, the channel structures 140 may be disposed on both or opposing sides of the back gate structures 120. The channel structures 140 may be spaced apart from each other in the X-direction and the Y-direction. An upper surface of the channel structure 140 may be coplanar with an upper surface of the back gate structure 120. A lower surface of the channel structure 140 may be in contact with the third conductive pattern 110c, and may be disposed on a level lower than the bottom of the back gate dielectric layer 122.

Each of the channel structures 140 may include a first source/drain region 142 in contact with the bit line structure 110, a second source/drain region 143 connected to the contact pattern 170, and a channel region 141 between the first source/drain region 142 and the second source/drain region 143. In an example embodiment, the first and second source/drain regions 142 and 143 may have an N-type conductivity type. The channel structure 140 may correspond to the channel region and source/drain regions of the cell transistor CTR illustrated in FIG. 1. In this specification, the channel structure 140 may be referred to as a 'cell channel structure.'

In an example embodiment, channel structures 140 may include a single crystal semiconductor material. The single crystal semiconductor material may include a group IV semiconductor, a group III-V compound semiconductor, or a group II-VI compound semiconductor, and may be, for example, a single crystal semiconductor including at least one of silicon, silicon carbide, germanium, or silicon-germanium.

However, according to example embodiments, the channel structures 140 may include at least one of a polycrystalline semiconductor material layer, an oxide semiconductor material layer such as indium gallium zinc oxide (IGZO), or a two-dimensional material layer such as MoS₂.

The oxide semiconductor layer may be indium gallium zinc oxide (IGZO). However, the example embodiment is not limited thereto. For example, the oxide semiconductor layer may include at least one of indium tungsten oxide (IWO), indium tin gallium oxide (ITGO), indium aluminium zinc oxide (IAZO), indium gallium oxide (IGO), indium tin zinc oxide (ITZO), zinc tin oxide (ZTO), indium zinc oxide (IZO), ZnO, indium gallium silicon oxide (IGSO), indium oxide (InO), tin oxide (SnO), titanium oxide (TiO), zinc oxynitride (ZnON), magnesium zinc oxide (MgZnO), indium zinc oxide (InZnO), indium gallium zinc oxide (InGaZnO), zirconium indium zinc oxide (ZrInZnO), hafnium indium zinc oxide (HfInZnO), tin indium zinc oxide (SnInZnO), aluminum tin indium zinc oxide (AlSnInZnO), silicon indium zinc oxide (SiInZnO), zinc tin oxide (ZnSnO), aluminum zinc tin oxide (AlZnSnO), gallium zinc tin oxide (GaZnSnO), zirconium zinc tin oxide (ZrZnSnO), and indium gallium silicon oxide (InGaSiO).

The two-dimensional material layer may include at least one of a transition metal dichalcogenide material layer (TMD material layer), a black phosphorous material layer, and a hBN material layer (hexagonal boron-nitride material layer), which may have semiconductor properties. For example, the two-dimensional material layer may include at least one of BiOSe, Crl, WSe₂, MoS₂, TaS, WS, SnSe, ReS, β-SnTe, MnO, AsS, P(black), InSe, h-BN, GaSe, GaN, SrTiO, MXene, and Janus 2D materials, which may form two-dimensional materials.

The word line 152 may be disposed on the bit line structure 110, and may be disposed on both or opposing side surfaces of the back gate structures 120. The word lines 152 may be spaced apart from each other in the X-direction and Y-direction. In plan view, the word line 152 may surround at least a portion of channel structures 140, and the channel structures 140 may be disposed between the back gate structures 120 and the word line 152. The term "surround" (or "cover" or "fill") as may be used herein may not require completely surrounding (or covering or filling) the described elements or layers, but may, for example, refer to partially surrounding (or covering or filling) the described elements or layers, for example, with at least one discontinuity therein. The word line 152 may correspond to the word line WL illustrated in FIG. 1.

The word line 152 may include doped polysilicon, a metal, conductive metal nitride, a metal-semiconductor compound, conductive metal oxide, conductive graphene, carbon nanotubes, or combinations thereof. For example, the word line 152 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, graphene, carbon nanotubes, or combinations thereof, but the present disclosure is not limited thereto. The word line 152 may include a single layer or multiple layers of the materials described above.

The memory cell array region CA may further include a gate dielectric layer 150 and an insulating structure 160. The gate dielectric layer 150 may be disposed between the word lines 152 and the channel structures 140, and may have a U-shape in cross-section. For example, the gate dielectric layer 150 may surround the word line 152 and the insulating structure 160.

In an example, each of the gate dielectric layers 150 may be a tunnel dielectric layer that does not include an information storage layer. For example, each of the gate dielectric layers 150 may include at least one of silicon oxide and high-κ dielectric. The high-κ dielectric may include metal oxide or metal oxynitride. For example, the high-κ dielectric may be formed of HfO₂, HfSiO, HfSiON, HfTaO, HfTiO, HfZrO, ZrO₂, Al₂O₃, or combinations thereof, but the present disclosure is not limited thereto. Each of the gate dielectric layers 150 may be formed of a single layer or multiple layers of the materials described above.

In another example, each of the gate dielectric layers 150 may include an information storage layer and a dielectric layer. For example, each of the gate dielectric layers 150 may have polarization characteristics depending on the electric field, and may include a ferroelectric layer that may have remnant polarization due to dipoles even in the absence of an external electric field. Data may be recorded using a polarization state within the ferroelectric layer. Accordingly, each of the gate dielectric layers 150 may include a ferroelectric layer, which may be referred to as an information storage layer. The ferroelectric layer, which may be the information storage layer may include a Hf-based compound, a Zr-based compound and/or a Hf-Zr-based compound. For example, the Hf-based compound may be a ferroelectric material based on HfO, the Zr-based compound may include ZrO-based ferroelectric materials, the Hf-Zr-based compound may include a ferroelectric material based on hafnium zirconium oxide (HZO). The ferroelectric layer, which may be the information storage layer, may include a ferroelectric material doped with impurities, for example, at least one of C, Si, Mg, Al, Y, N, Ge and Sn, Gd, La, Sc and Sr. For example, the ferroelectric layer, which may be the information storage layer, may be a material in which at least one of HfO₂, ZrO₂ and HZrO is doped with at least one of impurities such as C, Si, Mg, Al, Y, N, Ge, Sn, Gd, La, Sc and Sr.

In the gate dielectric layers 150, the information storage layer is not limited to the above-described types of materials, and may include other materials capable of storing information.

In plan view, the insulating structure 160 may be disposed between the back gate structures 120. For example, the insulating structures 160 may extend between adjacent word lines 152 in the Y-direction, and may be spaced apart from each other in the X-direction. The insulating structure 160 may be disposed on the word lines 152 and may extend between the word lines 152.

In an example embodiment, the insulating structure 160 may include a gate capping layer 162 and a capping pattern 164. The gate capping layers 162 may overlap the word lines 152 in the vertical direction, and may be in contact with the gate dielectric layers 150. The capping pattern 164 may extend between the word lines 152 and the gate capping layers 162 in the vertical direction. A lower surface of the capping pattern 164 may be in contact with the gate dielectric layer 150.

The gate capping layer 162 and the capping pattern 164 may include silicon oxide, silicon nitride, silicon oxynitride, silicon carbonitride, low-κ dielectric, or combinations thereof. For example, the gate capping layer 162 may include silicon nitride, and the capping pattern 164 may include silicon oxide. In some example embodiments, the gate capping layer 162 and the capping pattern 164 may include the same material and may be formed integrally.

The memory cell array region CA may further include insulating patterns 130 disposed between the channel structures 140 and disposed below the word lines 152. The insulating patterns 130 may be in contact with an upper surface of the third conductive pattern 110c, side surfaces of the channel structures 140, and lower surfaces of the gate dielectric layers 150. Lower surfaces of the insulating patterns 130 may be disposed on a level higher than that of lower surfaces of the channel structures 140. The insulating patterns 130 may include silicon oxide, silicon nitride, silicon oxynitride, silicon carbonitride, low-κ dielectric, or combinations thereof. For example, the insulating patterns 130 may include silicon oxide.

The contact patterns 170 may be disposed on the channel structures 140 and may be electrically connected to the channel structures 140. The contact patterns 170 may electrically connect the channel structures 140 and the information storage structure 180.

A lower surface of the contact patterns 170 is illustrated as being in contact with the channel structure 140 and the gate dielectric layer 150, but according to example embodiments, the lower surface of the contact patterns 170 may also be in contact with the insulating structure 160 and/or the upper capping layer 126.

The contact patterns 170 may include conductive materials such as doped single crystal silicon, doped polycrystalline silicon, a metal, conductive metal nitride, a metal-semiconductor compound, conductive metal oxide, conductive graphene, carbon nanotubes, or combinations thereof. In an example embodiment, the contact patterns 170 may include first to fourth contact layers 170a, 170b, 170c and 170d, which are sequentially stacked. For example, first contact layer 170a may include undoped polycrystalline silicon, the second contact layer 170b may include doped polycrystalline silicon, the third contact layer 170c may include a silicide material, and the fourth contact layer 170d may include a metal. However, according to example embodiments, the number of layers and type of material of the contact patterns 170 may be variously changed.

The memory cell array region CA may further include insulating patterns 175 disposed between the contact patterns 170. Each of the insulating patterns 175 may extend vertically and may be in contact with the insulating structure 160 or the upper capping layer 126. The insulating patterns 175 may spatially separate the contact patterns 170 and electrically insulate the contact patterns 170.

The information storage structures 180 may include first electrodes 182 electrically connected to the contact patterns 170, a second electrode 186 covering the first electrodes 182, and a dielectric layer 184 between the first electrodes 182 and the second electrode 186. The information storage structure 180 may correspond to the information storage element DS illustrated in FIG. 1.

In an example embodiment, the information storage structures 180 may be a capacitor configured to store information in a DRAM. For example, the dielectric layer 184 of the information storage structures 180 may be a capacitor dielectric layer of the DRAM, and the dielectric layer 184 may include high-κ dielectric, silicon oxide, silicon nitride, silicon oxynitride, or combinations thereof.

According to example embodiments, the information storage structures 180 may be structures that store memory information in a different way to DRAM. For example, the dielectric layer 184 of the information storage structures 180 may be a capacitor dielectric layer of a ferroelectric memory (e.g. FeRAM). In this case, the dielectric layer 184 may be a ferroelectric layer capable of recording data using a polarization state. Additionally, according to another example embodiment, the ferroelectric layer, that is, the dielectric layer 184 may also include a lower dielectric layer including at least one of silicon oxide or high-κ dielectric, and a ferroelectric layer disposed on the lower dielectric layer.

The memory cell array region CA may further include a lower insulating layer 101, wiring layers 103, vias 105, and first bonding pads BP1, which are disposed below the bit line structure 110. An upper surface of the lower insulating layer 101 may be in contact with a lower surface of the first conductive pattern 110a. The wiring layers 103 may be buried in the lower insulating layer 101 and may be arranged in a plurality of layers. The vias 105 may electrically connect the wiring layers 103.

The first bonding pads BP1 may be disposed along a lower surface of the lower insulating layer 101. For example, lower surfaces of the first bonding pads BP1 may be coplanar with lower surfaces of the lower insulating layer 101. The first bonding pads BP1 may be electrically connected to at least one of the wiring layers 103 and vias 105, respectively. Additionally, the bit line structure 110 may be electrically connected to at least one of the wiring layers 103 and the vias 105.

The second peripheral circuit region PERI2 of the second structure ST2 may include a device isolation layer 6 and a peripheral transistor TR, which are disposed on an upper surface of the substrate 3. The peripheral transistor TR may include peripheral source/drain regions SD, a peripheral gate dielectric layer GO, and a peripheral gate electrode GE. The peripheral transistor TR may be a planar type transistor. For example, the peripheral source/drain regions SD may be disposed on the upper surface of the substrate 3, and a channel region of the peripheral transistor TR may be disposed between the peripheral source/drain regions SD. The channel region may be coplanar with an upper surface of the peripheral source/drain regions SD, and may be in contact with a lower surface of the peripheral gate dielectric layer GO. The peripheral transistor TR may be a component of the sub-word line drivers and the sense amplifiers described above.

The second structure ST2 may further include an insulating layer 9, wiring layers 12, vias 15, and second bonding pads BP2, which are disposed on the substrate 3. The insulating layer 9 may cover the upper surface of the substrate 3, and may cover the peripheral transistor TR. The wiring layers 12 may be buried within the insulating layer 9 and may be arranged in a plurality of layers. The vias 15 may electrically connect the wiring layers 12.

The second bonding pads BP2 may be disposed along an upper surface of the insulating layer 9. For example, the upper surfaces of the second bonding pads BP2 may be coplanar with the upper surface of the insulating layer 9. Each of the second bonding pads BP2 may be bonded to a corresponding first bonding pad BP1. Each of the second bonding pads BP2 may be electrically connected to at least one of the wiring layers 12 and the vias 15. Additionally, the peripheral transistor TR may be electrically connected to at least one of the wiring layers 12 and the vias 15.

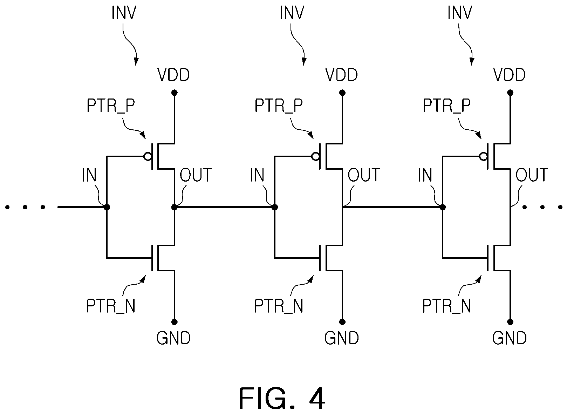

FIG. 4 is a circuit diagram of a peripheral circuit element of a first peripheral circuit region according to an example embodiment.

Referring to FIG. 4, in an example embodiment, a first peripheral circuit region may include an inverter circuit INV. The inverter circuit INV may be a complementary metal oxide semiconductor (CMOS) inverter circuit including peripheral transistors PTR_P and PTR_N. For example, the inverter circuit INV may include a PMOS transistor PTR _P and an NMOS transistor PTR_N. Gates of the PMOS transistor PTR_P and the NMOS transistor PTR_N may be electrically connected to an input node IN, and one of the source/drain regions of the PMOS transistor PTR_P may be electrically connected to a power supply voltage VDD, and the other of the source/drain regions may be electrically connected to an output node OUT. One of the source/drain regions of the NMOS transistor PTR_N may be electrically connected to a ground voltage GND, and the other of the source/drain regions may be electrically connected to the output node OUT. In an example embodiment, the inverter circuits INV may be included in an inverter array. For example, the input node IN of one inverter circuit INV may be electrically connected to the output node OUT of another adjacent inverter circuit INV.

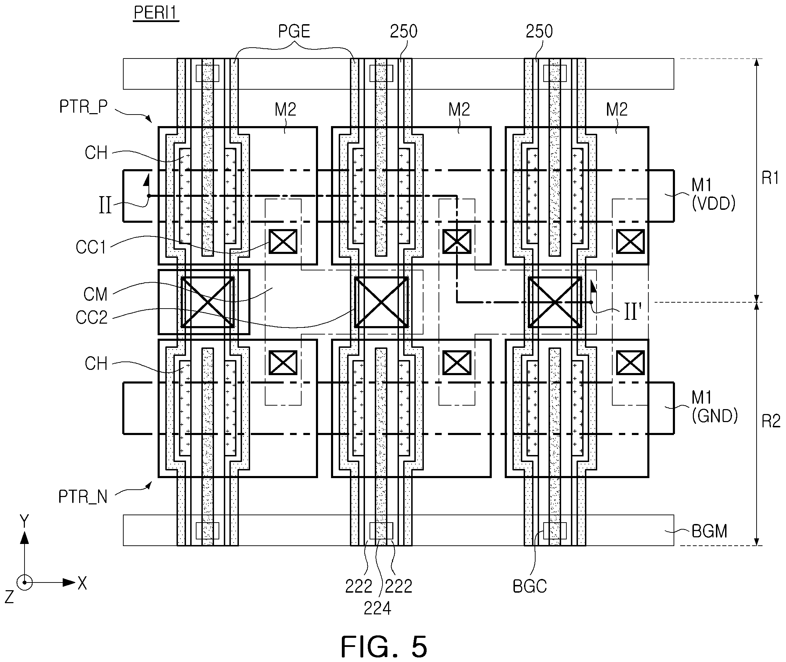

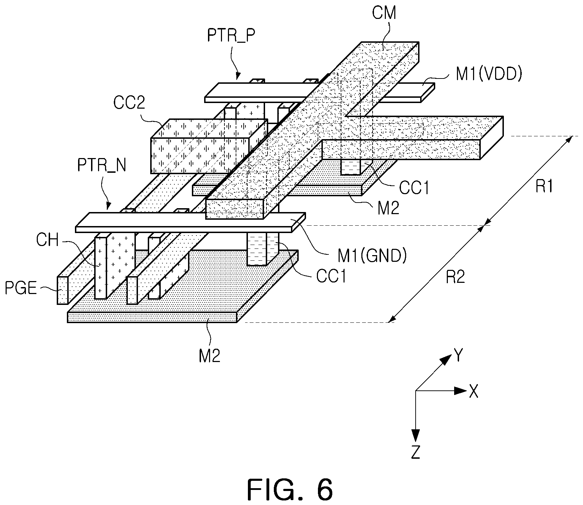

FIG. 5 is a plan view of a peripheral circuit element of a first peripheral circuit region according to an example embodiment. FIG. 6 is a schematic perspective view of the peripheral circuit element illustrated in FIG. 5. An equivalent circuit of FIG. 5 may be the inverter circuits illustrated in FIG. 4.

Referring to FIGS. 5 and 6, a first peripheral circuit region PERI1 may include an inverter circuit INV. The inverter circuit INV may include peripheral transistors (described with reference to peripheral channel structures CH and peripheral gate electrodes PGE), a first conductive line M1, a second conductive line M2, an interconnection line CM, a first connection contact CC1, and a second connection contact CC2.

The peripheral transistors CH and PGE may include a PMOS transistor PTR_P disposed on a first doped region R1 and an NMOS transistor PTR_N disposed on a second doped region R2. Here, the first doped region R1 may refer to a region in which a channel region of a peripheral channel structure CH of the peripheral transistors CH and PGE has a P-type conductivity type, and the second doped region R2 may refer to a region in which the channel region of the peripheral channel structure CH of the peripheral transistors CH and PGE has an N-type conductivity type.

Gates of the PMOS transistor PTR_P and NMOS transistor PTR_N may be electrically connected to each other by a peripheral gate electrode PGE. Here, a gate of the peripheral transistors CH and PGE may refer to a portion in which the channel region overlaps the peripheral gate electrode PGE in the X-direction.

The first conductive line M1 and the second conductive line M2 may be disposed on different levels, such as a vertical direction (e.g., Z-direction) that is perpendicular to the horizontal directions (e.g., X-direction and Y-direction). For example, the first conductive line M1 may be disposed on a first level, and the second conductive line M2 may be disposed on a second level, different from the first level. The first conductive line M1 and the second conductive line M2 may be spaced apart from each other in the vertical direction with the peripheral channel structure CH interposed therebetween. The first conductive line M1 may be electrically connected to the first source/drain regions 142 (see FIG. 3B) of the channel structure CH, and the second conductive line M2 may be electrically connected to the second source/drain regions 143 (see FIG. 3B) of the channel structure CH. In this specification, the first conductive line M1 and the second conductive line M2 may be referred to as 'upper interconnection' and 'lower interconnection', respectively. Spatially relative terms such as 'upper,' 'upper surface,' 'below,' 'lower,' 'lower surface,' 'side surface,' and the like may be denoted by reference numerals and refer to the drawings, except where otherwise indicated. It will be understood that such spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features.

One of the source/drain regions of the peripheral channel structure CH of the PMOS transistors PTR_P may be electrically connected to the first conductive line M1, and the other of the source/drain regions may be electrically connected to the corresponding second conductive line M2. One of the source/drain regions of a peripheral channel structure CH of the NMOS transistors PTR_N may be electrically connected to the first conductive line M1, and the other of the source/drain regions may be electrically connected to the corresponding second conductive line M2. A power supply voltage VDD may be applied to the first conductive line M1 electrically connected to the PMOS transistors PTR_P, and a ground voltage GND may be applied to the first conductive line M1 electrically connected to the NMOS transistors PTR_N.

The interconnection line CM may electrically connect the second conductive line M2 connected to the PMOS transistors PTR_P and the second conductive line M2 connected to the NMOS transistors PTR_N. The first connection contact CC1 may extend in the vertical direction, and may electrically connect the second conductive lines M2 to the interconnection line CM.

The second connection contact CC2 may electrically connect adjacent inverter circuits INV. For example, the second connection contact CC2 may extend from the interconnection line CM in the vertical direction, and may be electrically connected to the peripheral gate electrode PGE of the adjacent inverter circuit INV.

The inverter circuit INV may further include a back gate dielectric layer 222, a back gate electrode 224, a back gate contact BGC, and a third conductive line BGM. The back gate electrode 224 may extend between the peripheral gate electrodes PGE in the Y-direction. In the embodiment of Figs. 5 & 6, the back gate electrode 224 of the first doped region R1 is not electrically connected to the back gate electrode 224 of the second doped region R2. The back gate dielectric layer 222 may cover a side surface of the back gate electrode 224. As will be described below, the back gate dielectric layer 222 and the back gate electrode 224 may be components of a peripheral back gate structure 220.

The third conductive line BGM may be electrically connected to the back gate electrode 224 through the back gate contact BGC. In an example embodiment, the third conductive line BGM may be disposed on the same level as the first conductive line M1. In an example embodiment, components corresponding to the back gate contact BGC and the third conductive line BGM may also be disposed in the memory cell array region CA.

The inverter circuit INV may further include a gate dielectric layer 250 extending between the peripheral gate electrode PGE and the peripheral channel structure CH.

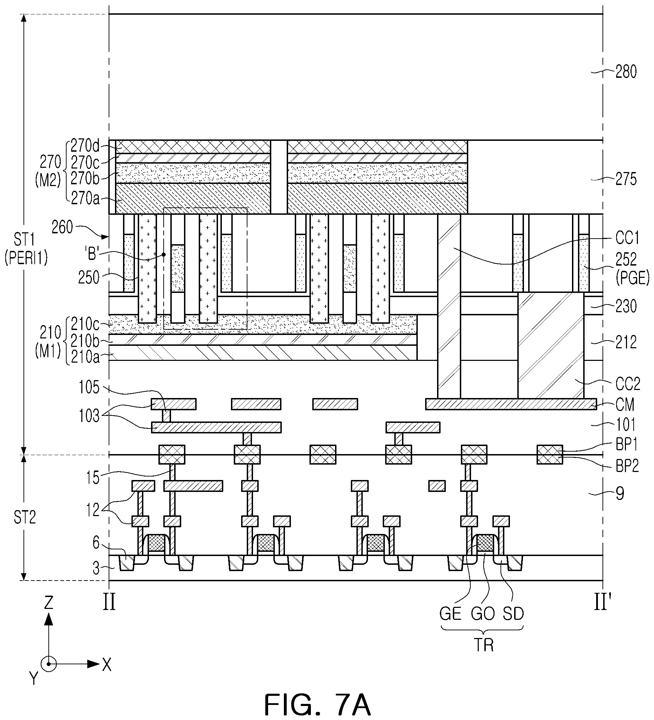

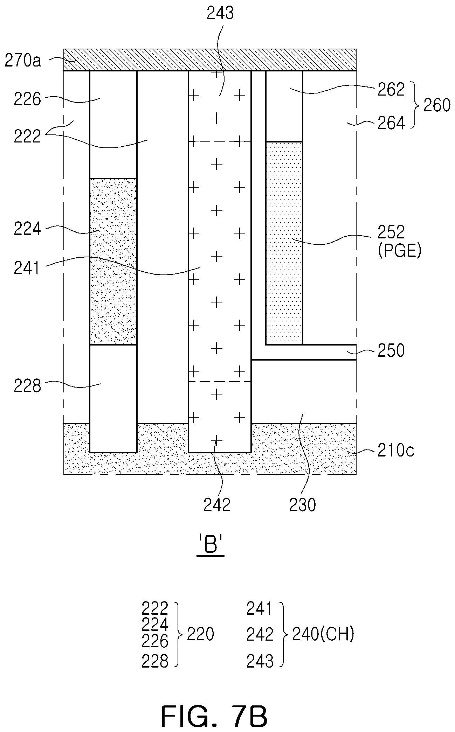

FIG. 7A is a vertical cross-sectional view taken along line II-II' of the peripheral circuit element illustrated in FIG. 5. FIG. 7B is a partially enlarged view of the semiconductor device illustrated in FIG. 7A.

Referring to FIGS. 7A and 7B, a first peripheral circuit region PERI1 may include a first conductive line 210, a peripheral back gate structure 220, a peripheral channel structure 240, a peripheral gate electrode 252, an insulating structure 260, and a second conductive line 270. The first conductive line 210 and the second conductive line 270 may correspond to the first conductive line M1 and the second conductive line M2 illustrated in FIGS. 5 and 6, respectively. The peripheral channel structure 240 and the peripheral gate electrode 252 may correspond to the peripheral channel structure CH and the peripheral gate electrode PGE illustrated in FIGS. 5 and 6, respectively.

The first peripheral circuit region PERI1 may include a peripheral transistor including a peripheral channel structure 240 and a peripheral gate electrode 252 disposed on at least one side surface of the peripheral channel structure 240. The peripheral transistor may have a structure similar to that of a vertical channel transistor in a memory cell array region CA.

At least a portion of the first conductive line 210 may be disposed on the same level as the bit line structure 110 in the memory cell array region CA, and may have a structure identical to or similar to that of the bit line structure 110. In an example embodiment, the first conductive line 210 may be electrically connected to the peripheral channel structure 240.

In an example embodiment, the first conductive line 210 may include a first conductive pattern 210a, a second conductive pattern 210b, and a third conductive pattern 210c, which are sequentially stacked. The first conductive pattern 210a, the second conductive pattern 210b, and the third conductive pattern 210c may be disposed on the same level and the same material as the first conductive pattern 210a, the second conductive pattern 210b, and the third conductive pattern 210c of the memory cell array region CA, respectively.

The peripheral back gate structure 220 may be disposed on the same level as the back gate structures 120, and may have a structure identical to or similar to that of the back gate structures 120.

The peripheral back gate structure 220 may include a back gate dielectric layer 222, a back gate electrode 224, an upper capping layer 226, and a lower capping layer 228. The back gate dielectric layer 222, the back gate electrode 224, the upper capping layer 226, and the lower capping layer 228 may be disposed on the same level and the same material as the back gate dielectric layer 222, the back gate electrode 224, the upper capping layer 226, and the lower capping layer 228 of the memory cell array region CA, respectively.

The first peripheral circuit region PERI1 may further include an upper capping layer 226 and a lower capping layer 228. The upper capping layer 226 and the lower capping layer 228 may be disposed above and below the back gate electrode 224, respectively.

The peripheral channel structure 240 may be disposed on the same level as the channel structure 140 in the memory cell array region CA, and may have a structure identical to or similar to that of the channel structure 140. In plan view, the peripheral channel structure 240 may be disposed on both or opposing side surfaces of the peripheral back gate structures 220. The peripheral channel structure 240 may extend in a vertical direction between the first conductive line 210 and the second conductive line 270.

Each of the peripheral channel structures 240 may include a first source/drain region 242 in contact with the first conductive line 210, a second source/drain region 243 connected to the second conductive line 270, and a channel region 241 between the first source/drain region 242 and the second source/drain region 243. The first and second source/drain regions 242 and 243 may respectively overlap the channel region 241 in the vertical direction, and may be disposed above and below the channel region 241. In an example embodiment, the first and second source/drain regions 242 and 243 may have an N-type or P-type conductivity type.

The peripheral gate electrode 252 may be disposed on the same level as the word line 152 of the memory cell array region CA and may have a structure identical to or similar to that of the word line 152. The peripheral channel structure 240 and the peripheral gate electrode 252 may be included in the peripheral transistors PTR _P and PTR_N illustrated in FIG. 4. The channel structure 240 may correspond to a source/drain region and channel region of the peripheral transistors PTR _P and PTR_N. A portion in which the peripheral gate electrode 252 overlaps the channel structure 240 in the X-direction may correspond to gates of the peripheral transistors PTR_P and PTR_N.

The first peripheral circuit region PERI1 may further include a gate dielectric layer 250 and an insulating structure 260. The gate dielectric layer 250 may be disposed between the peripheral gate electrodes 252 and the peripheral channel structures 240, and may have a U-shape in cross-section. For example, the gate dielectric layer 250 may surround the peripheral gate electrode 252 and the insulating structure 260.

In plan view, the insulating structure 260 may be disposed between the peripheral back gate structures 220. For example, the insulating structures 260 may extend between adjacent peripheral gate electrodes 252 in the Y-direction and may be spaced apart from each other in the X-direction. The insulating structure 260 may be disposed on the peripheral gate electrodes 252 and may extend between the peripheral gate electrodes 252. In an example embodiment, the insulating structure 260 may include a gate capping layer 262 and a capping pattern 264.

The first peripheral circuit region PERI1 may further include insulating patterns 230 disposed between the peripheral channel structures 240 and disposed below the peripheral gate electrodes 252.

The second conductive line 270 may be disposed on the peripheral channel structures 240 and may be electrically connected to the peripheral channel structures 240. At least a portion of the second conductive line 270 may be disposed on the same level as the contact patterns 170 of the memory cell array region CA and may have a structure identical to or similar to that of the contact patterns 170. The second conductive line 270 may include first to fourth contact layers 270a, 270b, 270c and 270d, which are sequentially stacked. The first to fourth contact layers 270a, 270b, 270c and 270d may be disposed on the same level and the same material as the first to fourth contact layers 170a, 170b, 170c and 170d of the memory cell array region CA, respectively.

The first peripheral circuit region PERI1 may further include insulating patterns 275 disposed between the second conductive lines 270 and an upper insulating layer 280 on the second conductive lines 270.

The first peripheral circuit region PERI1 may further include an interconnection line CM, a first connection contact CC1, a second connection contact CC2, and an interlayer insulating layer 212. The interconnection line CM may be disposed on a level different from the first conductive line 210 (first level) and the second conductive line 270 (second level). In an example embodiment of Fig. 7A, the interconnection line CM may be disposed on a third level, and the first level may be disposed between the second level and the third level. For example, the interconnection line CM may be disposed on the same level as one of the wiring layers 103.

The first connection contact CC1 may vertically penetrate through the insulating structure 260, the insulating pattern 230, and the interlayer insulating layer 212, and may connect the second conductive line 270 and the interconnection line CM. The second connection contact CC2 may connect the interconnection line CM and the peripheral gate electrodes 252.

As illustrated in FIGS. 1 to 7B, the first peripheral circuit region PERI1 may be disposed in the first structure ST1 horizontally or laterally adjacent or spaced apart from the memory cell region CA, rather than in the second structure ST2. Accordingly, a size of the semiconductor device 100 may be reduced as compared to a structure in which peripheral circuit regions are disposed only in the second structure ST2, which is under the memory cell region CA or between the memory cell region CA and the substrate 3. Additionally, since the peripheral transistors PTR _P and PTR_N of the first peripheral circuit region PERI1 have a structure similar to that of the cell transistor CTR in the memory cell array region CA (e.g., a vertical channel structure), the semiconductor device may be formed relatively simply without adding excessive complexity to the fabrication processes.

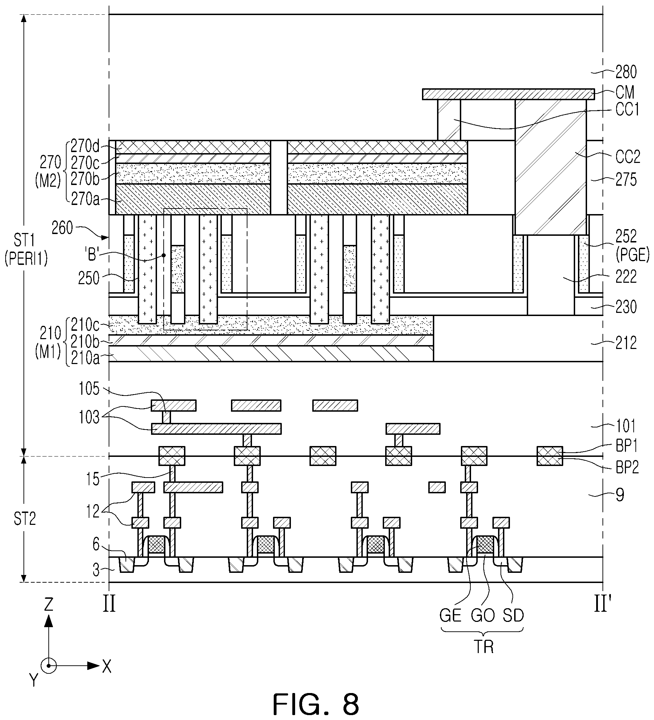

FIG. 8 is a vertical cross-sectional view of a peripheral circuit element of a first peripheral circuit region according to an example embodiment.

Referring to FIG. 8, a first peripheral circuit region PERI1 may include an interconnection line CM electrically connecting a first conductive line 210 and a second conductive line 270, a first connection contact CC1, and a second connection contact CC2. The first conductive line 210 is electrically connected to the second conductive line 270 through peripheral channel structures 240.

The interconnection line CM may be disposed on a different level from the first conductive line 210 and the second conductive line 270. In an example embodiment, the first conductive line 210, the second conductive line 270, and the interconnection line CM may be disposed on a first level, a second level and a third level, which are different from each other, respectively. The second level may be disposed between the first level and the third level, as shown in Fig. 8. For example, the interconnection line CM may be disposed on the same level as the information storage structure 180 in the memory cell array area CA.

The first connection contact CC1 may penetrate through the upper insulating layer 280 and may connect the interconnection line CM to the second conductive line 270. The second connection contact CC2 may penetrate through the upper insulating layer 280 and the insulating pattern 275, and may connect the interconnection line CM to the peripheral gate electrodes PGE.

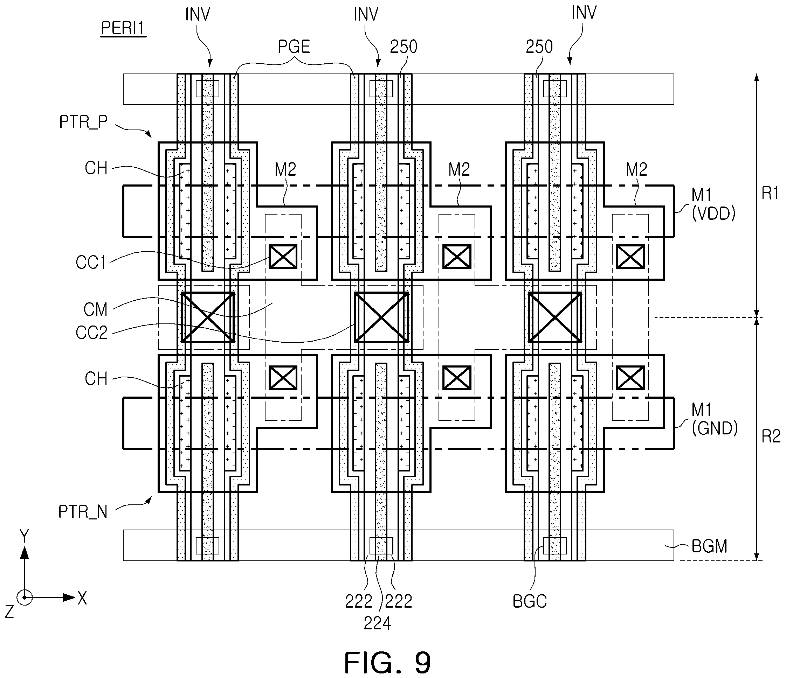

FIGS. 9 to 12 are plan views of peripheral circuit elements of a first peripheral circuit region according to an example embodiment.

Referring to FIG. 9, a first peripheral circuit region PERI1 may include an inverter circuit INV (see FIG. 4). In an example embodiment, a second conductive line M2 of the inverter circuit INV may include a first portion vertically overlapping a peripheral channel structure CH and a second portion extending from a side surface of the first portion in the X-direction, in plan view.

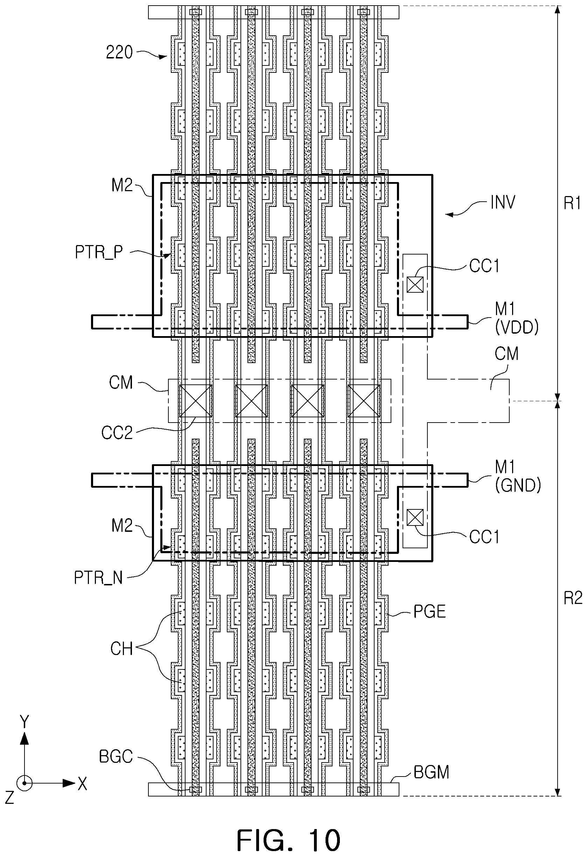

Referring to FIG. 10, the first peripheral circuit region PERI1 may include an inverter circuit INV(see FIG. 4). In an example embodiment, a first conductive line M1 and a second conductive line M2 of the inverter circuit INV may be electrically connected to a plurality of peripheral channel structures CH spaced apart from each other in the X-direction and the Y-direction. For example, a plurality of peripheral back gate structures 220 may be spaced apart from each other along the X-direction, and the first conductive line M1 and the second conductive line M2 may be disposed across the plurality of peripheral back gate structures 220. The peripheral channel structures CH may be disposed on both or opposing sides of each peripheral back gate structure 220, and a plurality of peripheral channel structures CH may be electrically connected to the first conductive line M1 and the second conductive line M2.

In an example embodiment, a size of the first conductive line M1 and the second conductive line M2 on the first doped region R1 may be larger than a size of the first conductive line M1 and the second conductive line M2 on the second doped region R2. For example, the number of PMOS transistors PTR _P included in the inverter circuit INV may be more than the number of NMOS transistors PTR_N. The number of peripheral channel structures CH electrically connected to the first conductive line M1 and the second conductive line M2 on the first doped region R1 may be greater than the number of peripheral channel structures CH electrically connected to the first conductive line M1 and the second conductive line M2 on the second doped region R2. Accordingly, a current flowing along the peripheral channel structure CH of the PMOS transistor PTR _P in the first doped region R1 may be increased, and electrical characteristics of the inverter circuit INV may be improved.

In some example embodiments, a size of the first conductive line M1 and the second conductive line M2 on the first doped region R1 may be equal to a size of the first conductive line M1 and the second conductive line M2 on the second doped region R2.

The inverter circuit INV may be connected to another adjacent inverter circuit INV. For example, the inverter circuit INV may be electrically connected to an interconnection line CM of another inverter circuit INV through a plurality of second connection contacts CC2. The plurality of second connection contacts CC2 may be electrically connected to a plurality of peripheral gate electrodes PGE.

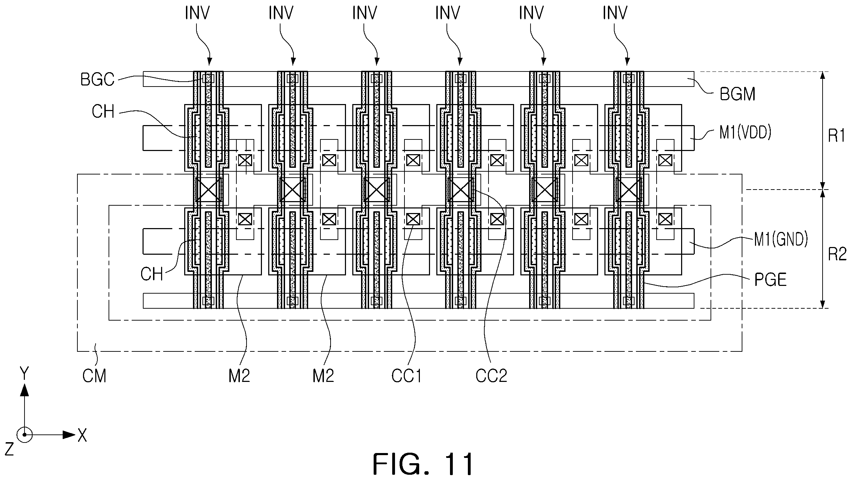

Referring to FIG. 11, the first peripheral circuit region PERI1 may include a ring oscillator. The ring oscillator may include a plurality of inverter circuits INV electrically connected to each other.

In an example embodiment, the ring oscillator may include first to sixth inverter circuits INV included in inverter arrays spaced apart from each other in the X-direction. The peripheral gate electrode PGE of each of the first to sixth inverter circuits INV may be electrically connected to an interconnection line CM of a corresponding other inverter circuit INV through the second connection contact CC2. For example, the peripheral gate electrodes PGE of the second to sixth inverter circuits INV may be electrically connected to the interconnection line CM of the first to fifth inverter circuits INV, respectively. Additionally, the peripheral gate electrode PGE of the first inverter circuit INV may be electrically connected to an interconnection line CM of the sixth inverter circuit INV. The number of inverter circuits (INV) included in the ring oscillator illustrated in FIG. 11 is an example, and the present disclosure is not limited thereto.

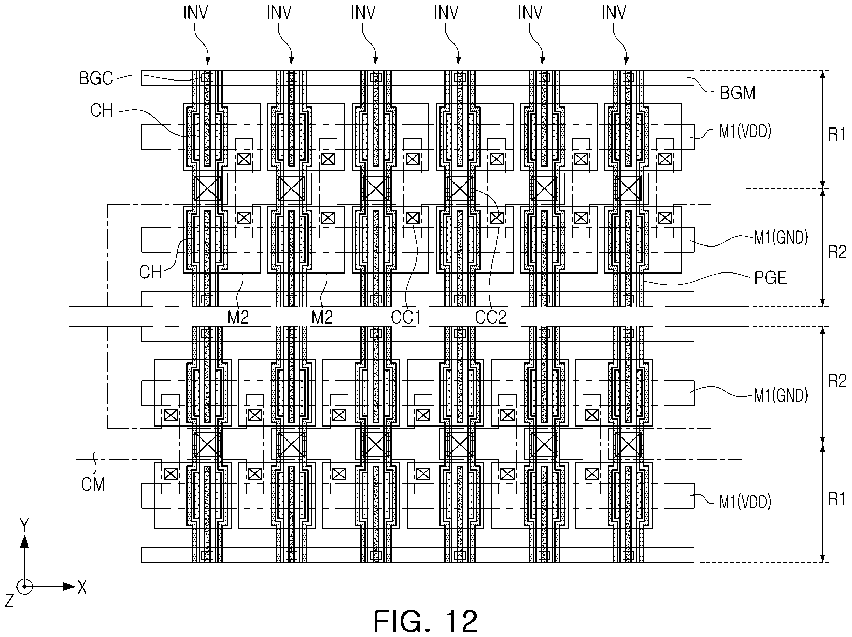

Referring to FIG. 12, the first peripheral circuit region PERI1 may include a ring oscillator. The ring oscillator may include a plurality of inverter circuits INV electrically connected to each other. For example, the ring oscillator may include inverter arrays spaced apart from each other in the Y-direction and electrically connected by the interconnection line CM. Each of the inverter arrays may include a plurality of inverter circuits INV spaced apart from each other in the X-direction.

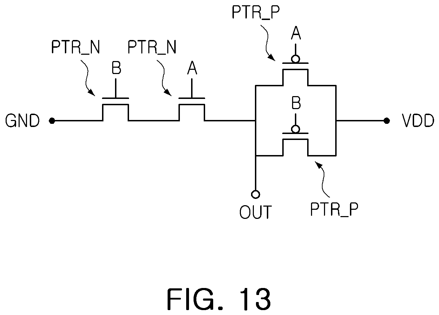

FIG. 13 is a circuit diagram of a peripheral circuit element of a first peripheral circuit region according to an example embodiment.

Referring to FIG. 13, in an example embodiment, the first peripheral circuit region PERI1 may include a NAND gate circuit. The NAND gate circuit may be a CMOS NAND gate circuit including peripheral transistors PTR_P and PTR_N. For example, the NAND gate circuit may include two PMOS transistors PTR _P and two NMOS transistors PTR_N. The two PMOS transistors PTR _P may be connected to each other in parallel, and the two NMOS transistors PTR_N may be connected in series with each other.

One PMOS transistor PTR_P and one NMOS transistor PTR_N among the peripheral transistors PTR _P and PTR_N may share gate A, and one PMOS transistor PTR _P and one NMOS transistor PTR_N among the peripheral transistors PTR _P and PTR_N may share gate B.

One of the source/drain regions of the NMOS transistor PTR_N connected to gate B may be electrically connected to a ground voltage GND. One of the source/drain regions of each of the PMOS transistors PTR _P may be electrically connected to a power supply voltage VDD, and the other of the source/drain regions may be electrically connected to an output node OUT.

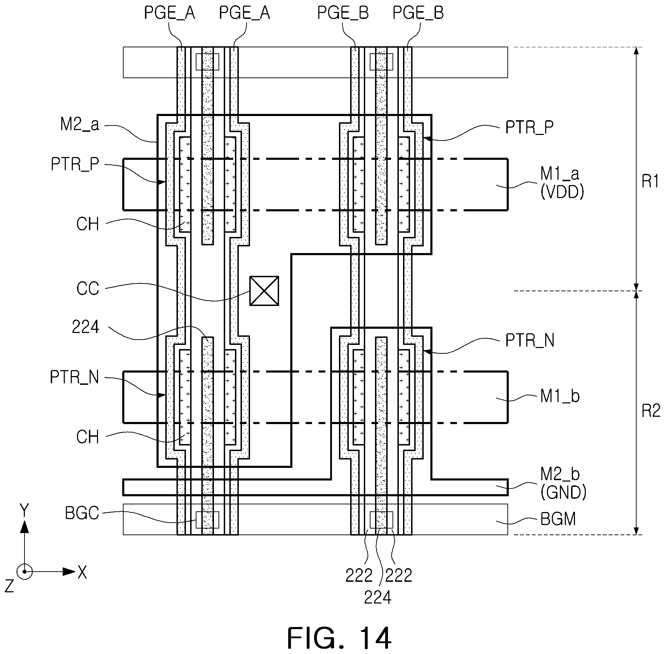

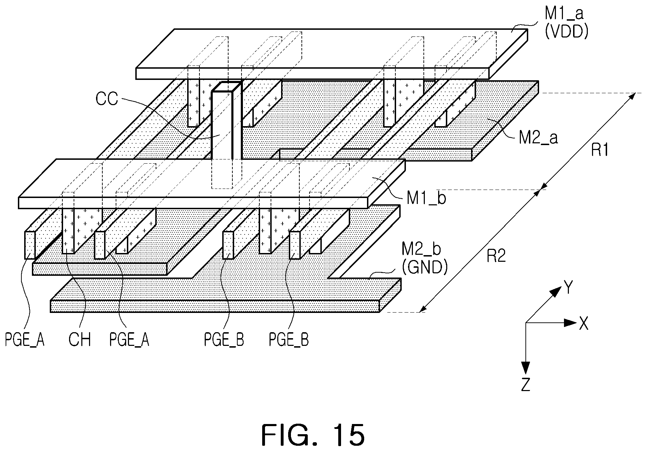

FIG. 14 is a plan view of a peripheral circuit element of a first peripheral circuit region according to an example embodiment. FIG. 15 is a schematic perspective view of a peripheral circuit element illustrated in FIG. 14.

Referring to FIGS. 14 and 15, a first peripheral circuit region PERI1 may include a NAND gate circuit. FIG. 13 may be an equivalent circuit of the NAND gate circuit illustrated in FIGS. 14 and 15.

The NAND gate circuit may include peripheral transistors PTR_P and PTR_N, first peripheral gate electrodes PGE_A, second peripheral gate electrodes PGE_B, a first upper interconnection M1_a, a second upper interconnection M1_b, a first lower interconnection M2_a, a second lower interconnection M2_b, and a connection contact CC.

The peripheral transistors PTR_P and PTR_N may include PMOS transistors PTR_P disposed on the first doped region R1 and NMOS transistors PTR_N disposed on the second doped region R2. Some PMOS transistors PTR _P and some NMOS transistors PTR_N may share the first peripheral gate electrode PGE_A. For example, gates of some PMOS transistors PTR _P and gates of some NMOS transistors PTR_N may be connected to the first peripheral gate electrode PGE_A. Some PMOS transistors PTR_P and some NMOS transistors PTR_N may share the second peripheral gate electrode PGE_B.

The first upper interconnection M1_a and the first lower interconnection M2_a may be disposed on the first doped region R1, and may connect the PMOS transistors PTR_P in parallel. The power supply voltage VDD may be applied to the first upper interconnection M1_a. The second upper interconnection M1_b and the second lower interconnection M2_b may be disposed on the second doped region R2, and may connect the NMOS transistors PTR_N in series. The ground voltage GND may be applied to the second lower interconnection M2_b. The connection contact CC electrically connected to the output node OUT of the NAND gate circuit may be disposed on the first lower interconnection M2_a. In an example embodiment, the connection contact CC may be electrically connected to a wiring layer disposed on the same level as one of the wiring layers 103 illustrated in FIG. 7A.

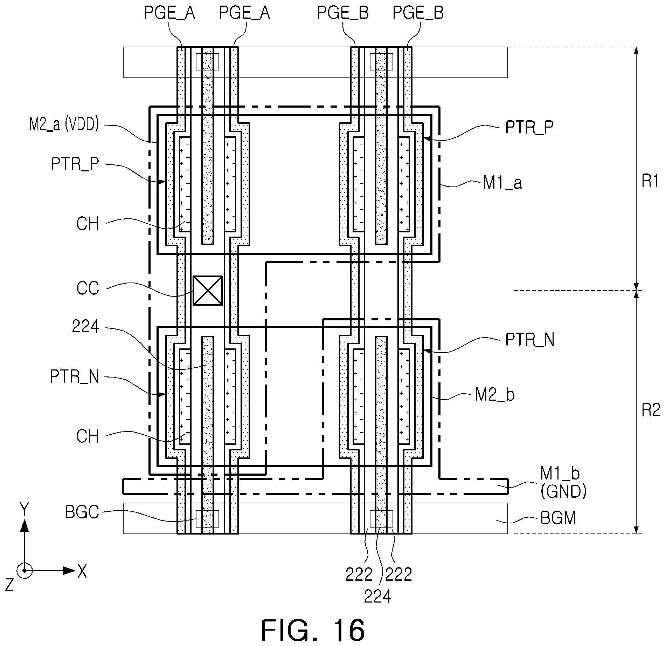

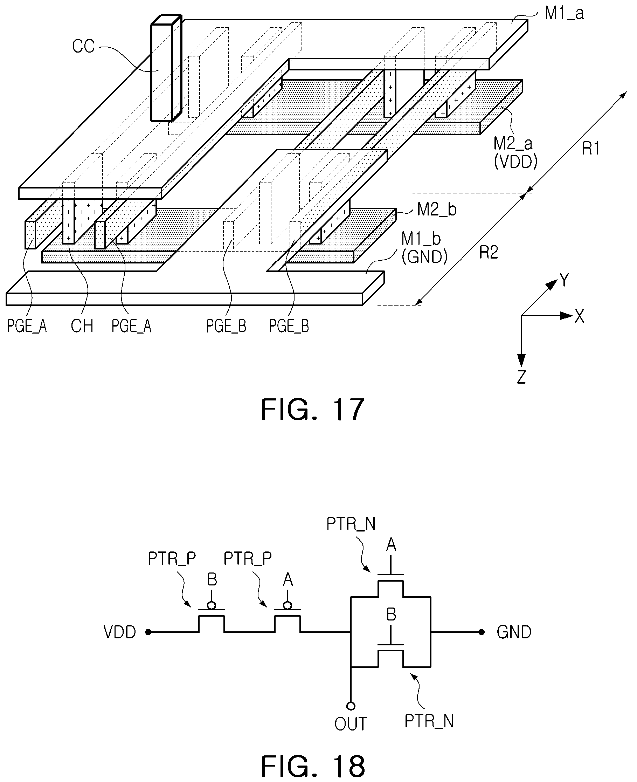

FIG. 16 is a plan view of a peripheral circuit element of a first peripheral circuit region according to an example embodiment. FIG. 17 is a schematic perspective view of a peripheral circuit element illustrated in FIG. 16.

Referring to FIGS. 16 and 17, the first peripheral circuit region PERI1 may include a NAND gate circuit. FIG. 13 may be an equivalent circuit of the NAND gate circuit illustrated in FIGS. 16 and 17. Unlike the NAND gate circuit illustrated in FIGS. 14 and 15, the power supply voltage VDD may be applied to the first lower interconnection M2_a, and the ground voltage GND may be applied to the second upper interconnection M1_b. The connection contact CC may be disposed on the first upper interconnection M1_a.

FIG. 18 is a circuit diagram of a peripheral circuit element of a first peripheral circuit region according to an example embodiment.

Referring to FIG. 18, in an example embodiment, a first peripheral circuit region PERI1 may include a NOR gate circuit. The NOR gate circuit may be a CMOS NOR gate circuit including peripheral transistors PTR_P and PTR_N. For example, the NOR gate circuit may include two PMOS transistors PTR_P and two NMOS transistors PTR_N. Unlike the example embodiment NAND gate circuit of FIG. 13, the two PMOS transistors PTR _P may be connected to each other in series, and the two NMOS transistors PTR_N may be connected to each other in parallel.

One of the source/drain regions of the PMOS transistor PTR_P connected to gate B may be electrically connected to a supply voltage VDD. One of the source/drain regions of each of the NMOS transistors PTR_N may be electrically connected to a ground voltage GND, and the other of the source/drain regions may be electrically connected to an output node OUT.

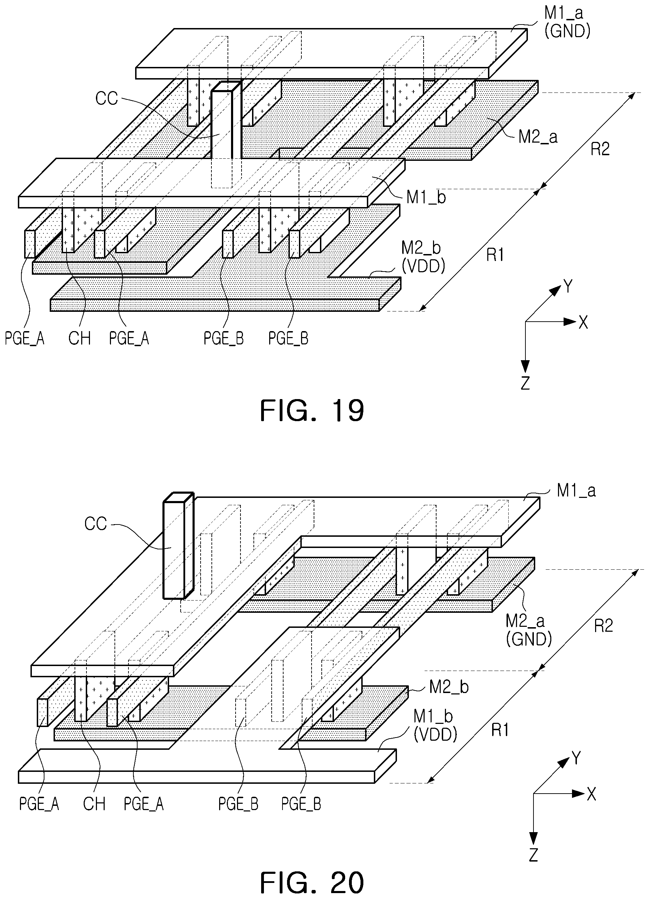

FIGS. 19 and 20 are schematic perspective views of peripheral circuit elements in a first peripheral circuit region according to an example embodiment.

Referring to FIG. 19, a first peripheral circuit region PERI1 may include a NOR gate circuit. FIG. 18 may be an equivalent circuit of a NOR gate circuit illustrated in FIG. 19.

The NOR gate circuit may have a structure similar to that of the NAND gate circuit illustrated in FIG. 15. However, unlike the example embodiment of FIG. 15, a first upper interconnection M1_a and a first lower interconnection M2_a may be disposed on the second doped region R2, and may connect NMOS transistors PTR_N in parallel. A ground voltage GND may be applied to a first upper interconnection M1_a. A second upper interconnection M1_b and the second lower interconnection M2_b may be disposed on the first doped region R1, and may connect PMOS transistors PTR _P in series. A power supply voltage VDD may be applied to the second lower interconnection M2_b. A connection contact CC electrically connected to an output node OUT of the NOR gate circuit may be disposed on the first lower interconnection M2_a.

Referring to FIG. 20, the first peripheral circuit region PERI1 may include a NOR gate circuit. FIG. 18 may be an equivalent circuit of the NOR gate circuit illustrated in FIG. 20.

The NOR gate circuit may have a structure similar to that of the NAND gate circuit illustrated in FIG. 17. However, unlike the example embodiment of FIG. 17, the first upper interconnection M1_a and the first lower interconnection M2_a may be disposed on the second doped region R2, and may connect the NMOS transistors PTR_N in parallel. The ground voltage GND may be applied to the first lower interconnection M2_a. The second upper interconnection M1_b and the second lower interconnection M2_b may be disposed on the first doped region R1, and may connect the PMOS transistors PTR _P in series. The power supply voltage VDD may be applied to the second upper interconnection M1_b. The connection contact CC electrically connected to the output node OUT of the NOR gate circuit may be disposed on the first upper interconnection M1_a.

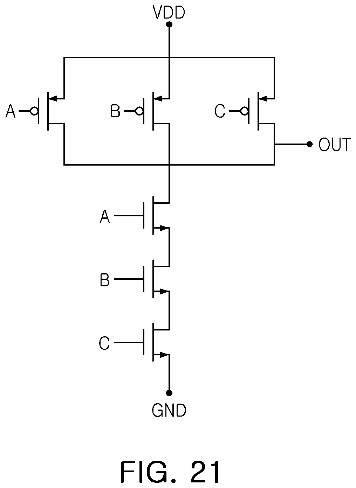

FIG. 21 is a circuit diagram of a peripheral circuit element of a first peripheral circuit region according to an example embodiment.

Referring to FIG. 21, in an example embodiment, a first peripheral circuit region PERI1 may include a NAND gate circuit. The NAND gate circuit may be a CMOS NAND gate circuit including peripheral transistors PTR_P and PTR_N. For example, the NAND gate circuit may include three PMOS transistors PTR_P and three NMOS transistors PTR_N. The three PMOS transistors PTR _P may be connected to each other in parallel, and the three NMOS transistors PTR_N may be connected to each other in series.

One PMOS transistor PTR_P and one NMOS transistor PTR_N among the peripheral transistors PTR _P and PTR_N may share gate A, and one PMOS transistor PTR _P and one NMOS transistor PTR_N among the peripheral transistors PTR_P and PTR_N may share gate B. One PMOS transistor PTR _P and one NMOS transistor PTR_N among the peripheral transistors PTR_P and PTR_N may share gate C.

One of the source/drain regions of the NMOS transistor PTR_N connected to the gate C may be electrically connected to the ground voltage GND. One of the source/drain regions of each of the PMOS transistors PTR_P may be electrically connected to the supply voltage VDD, and the other the source/drain regions may be electrically connected to the output node OUT.

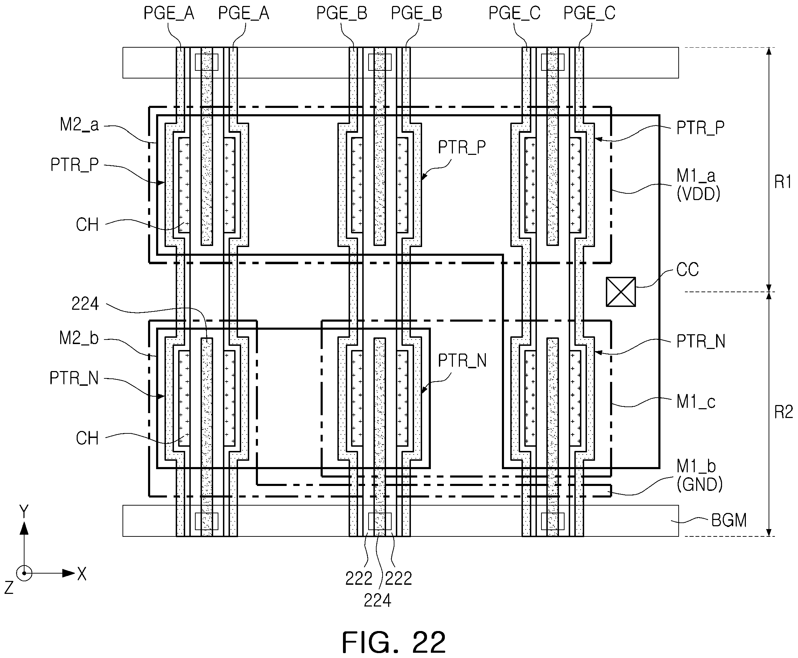

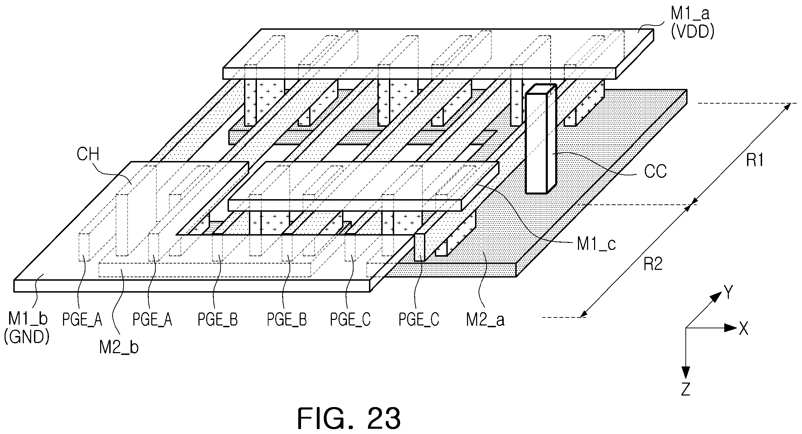

FIG. 22 is a plan view of a peripheral circuit element of a first peripheral circuit region according to an example embodiment. FIG. 23 is a schematic perspective view of a peripheral circuit element illustrated in FIG. 22

Referring to FIGS. 22 and 23, a first peripheral circuit region PERI1 may include a NAND gate circuit. FIG. 21 may be an equivalent circuit of the NAND gate circuit illustrated in FIGS. 22 and 23.

The NAND gate circuit may include peripheral transistors PTR_P and PTR_N, first peripheral gate electrodes PGE_A, second peripheral gate electrodes PGE_B, third peripheral gate electrodes PGE_C, a first upper interconnection M1_a, a second upper interconnection M1_b, a third upper interconnection M1_c, a first lower interconnection M2_a, a second lower interconnection M2_b, and a connection contact CC.

The peripheral transistors PTR_P and PTR_N may include PMOS transistors PTR_P disposed on a first doped region R1 and NMOS transistors PTR_N disposed on a second doped region R2. Some PMOS transistors PTR_P and some NMOS transistors PTR_N may share a first peripheral gate electrode PGE_A. Some PMOS transistors PTR _P and some NMOS transistors PTR_N share a second peripheral gate electrode PGE_B. Some PMOS transistors PTR _P and some NMOS transistors PTR_N may share a third peripheral gate electrode PGE_C.

The first upper interconnection M1_a and the first lower interconnection M2_a may connect the PMOS transistors PTR _P in parallel. A power supply voltage VDD may be applied to the first upper interconnection M1_a. The second upper interconnection M1_b, the third upper interconnection M1_c, and the second lower interconnection M2_b may be disposed on the second doped region R2, and may connect the NMOS transistors PTR_N in series. A ground voltage GND may be applied to the second upper interconnection M1_b. The connection contact CC electrically connected to an output node OUT of the NAND gate circuit may be disposed on the first lower interconnection M2_a.

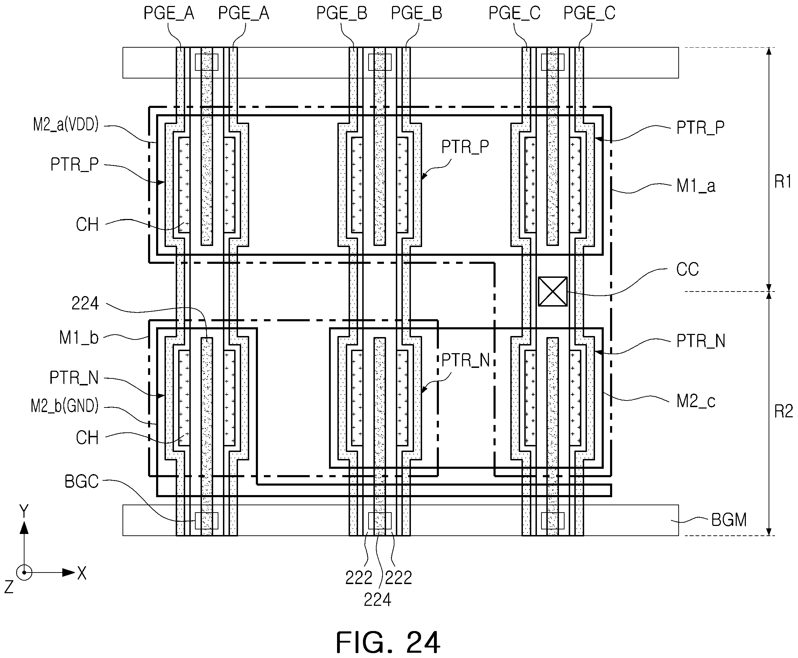

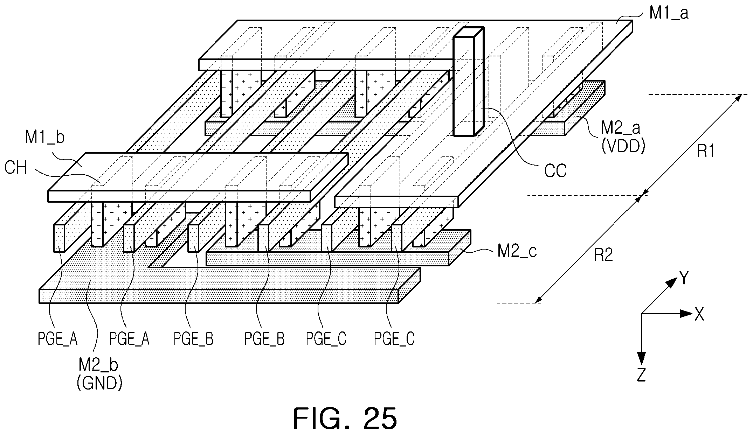

FIG. 24 is a plan view of a peripheral circuit element of a first peripheral circuit region according to an example embodiment, and FIG. 25 is a schematic perspective view of a peripheral circuit element illustrated in FIG. 24.

Referring to FIGS. 24 and 25, a first peripheral circuit region PERI1 may include a NAND gate circuit. FIG. 21 may be an equivalent circuit of the NAND gate circuit illustrated in FIGS. 24 and 25. Unlike the NAND gate circuit illustrated in FIGS. 22 and 23, a power supply voltage VDD may be applied to a first lower interconnection M2_a, and a ground voltage GND may be applied to a second lower interconnection M2_b. A connection contact CC may be disposed on a first upper interconnection M1_a. The first upper interconnection M1_a and the first lower interconnection M2_a may connect PMOS transistors PTR_P in parallel. The second upper interconnection M1_b, the second lower interconnection M2_b, and the third lower interconnection M2_c may be disposed on a second doped region R2, and may connect NMOS transistors PTR_N in series.

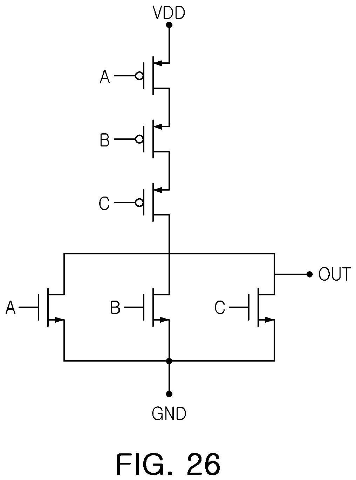

FIG. 26 is a circuit diagram of a peripheral circuit element of a first peripheral circuit region according to an example embodiment.

Referring to FIG. 26, in an example embodiment, a first peripheral circuit region PERI1 may include a NOR gate circuit. The NOR gate circuit may be a CMOS NOR gate circuit including peripheral transistors PTR_P and PTR_N. For example, the NOR gate circuit may include three PMOS transistors PTR _P and three NMOS transistors PTR_N. Unlike the example embodiment NAND gate circuit of FIG. 21, the three PMOS transistors PTR_P may be connected to each other in series, and the three NMOS transistors PTR_N may be connected to each other in parallel.

One of the source/drain regions of the PMOS transistor PTR_P connected to gate A may be electrically connected to a supply voltage VDD. One of the source/drain regions of each of the NMOS transistors PTR_N may be electrically connected to a ground voltage GND, and the other of the source/drain regions may be electrically connected to an output node OUT.

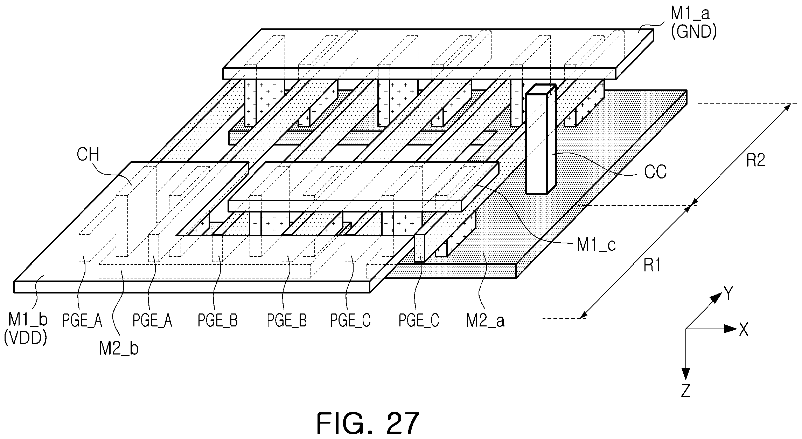

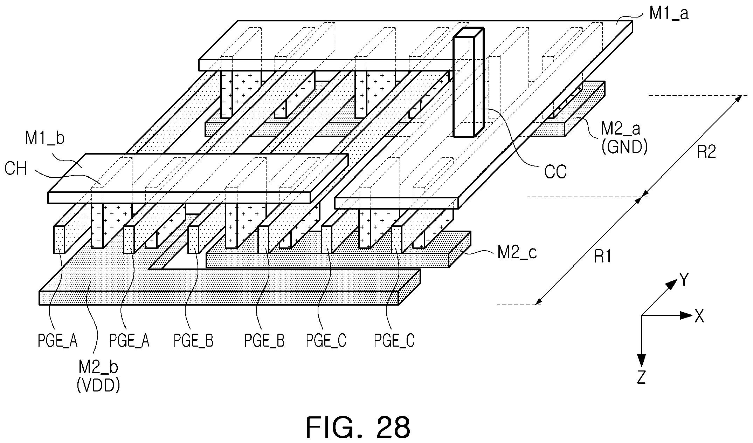

FIGS. 27 and 28 are schematic perspective views of a peripheral circuit element in a first peripheral circuit region according to an example embodiment.

Referring to FIG. 27, a first peripheral circuit region PERI1 may include a NOR gate circuit. FIG. 26 may be an equivalent circuit of a NOR gate circuit illustrated in FIG. 27.

The NOR gate circuit may have a structure similar to that of the NAND gate circuit illustrated in FIG. 23. However, unlike the example embodiment of FIG. 23, a first upper interconnection M1_a and a first lower interconnection M2_a may be disposed on a second doped region R2, and may connect NMOS transistors PTR_N in parallel. A ground voltage GND may be applied to the first upper interconnection M1_a. A second upper interconnection M1_b, a third upper interconnection M1_c, and a second lower interconnection M2_b may be disposed on a first doped region R1, and may connect PMOS transistors PTR_P in series. A power supply voltage VDD may be applied to the second upper interconnection M1_b. A connection contact CC electrically connected to an output node OUT of the NOR gate circuit may be disposed on the first lower interconnection M2_a.

Referring to FIG. 28, a first peripheral circuit region PERI1 may include a NOR gate circuit. FIG. 26 may be an equivalent circuit of the NOR gate circuit illustrated in FIG. 28.

The NOR gate circuit may have a structure similar to that of the NAND gate circuit illustrated in FIG. 25. However, unlike the example embodiment of FIG. 25, a first upper interconnection M1_a and a first lower interconnection M2_a may be disposed on a second doped region R2, and may connect NMOS transistors PTR_N in parallel. A ground voltage GND may be applied to the first lower interconnection M2_a. A second upper interconnection M1_b, a second lower interconnection M2_b, and a third lower interconnection M2_c may be disposed on a first doped region R1, and may connect PMOS transistors PTR _P in series. A power supply voltage VDD may be applied to the second lower interconnection M2_b. A connection contact CC electrically connected to an output node OUT of the NOR gate circuit may be disposed on the first upper interconnection M1_a.

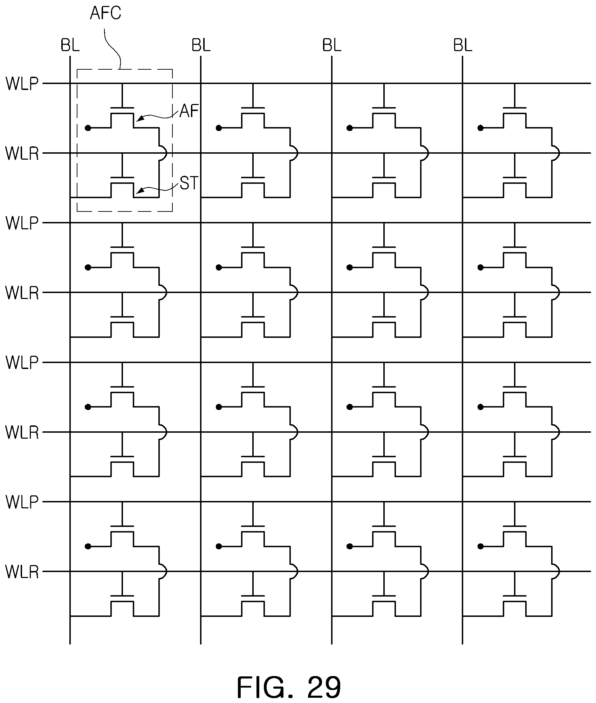

FIG. 29 is a circuit diagram of a peripheral circuit element of a first peripheral circuit region according to an example embodiment.

Referring to FIG. 29, in an example embodiment, a first peripheral circuit region PERI1 may include an antifuse array. The antifuse array may include antifuse memory cells AFC arranged along bit lines BL, programming word lines WLP, and read word lines WLR. Each of the antifuse memory cells AFC may include a selection transistor ST and an antifuse AF connected in series. In an example embodiment, the selection transistor ST and the antifuse AF may be disposed in a second doped region R2.

The selection transistor ST may be connected between the bit lines BL and the antifuse AF, and may be controlled by the read word lines WLR. The read word lines WLR may be connected to selection gates of the selection transistors ST.

A drain region of the antifuse AF may be connected to a drain region of the selection transistor ST, and a source region of the antifuse AF may electrically float. The antifuse AF may be programmed by applying a high voltage to an antifuse gate dielectric layer and performing dielectric breakdown on the antifuse gate dielectric layer. The antifuse AF may be programmed according to a voltage applied to the programming word lines WLP. The programming word lines WLP may be connected to antifuse gates of the antifuses AF.

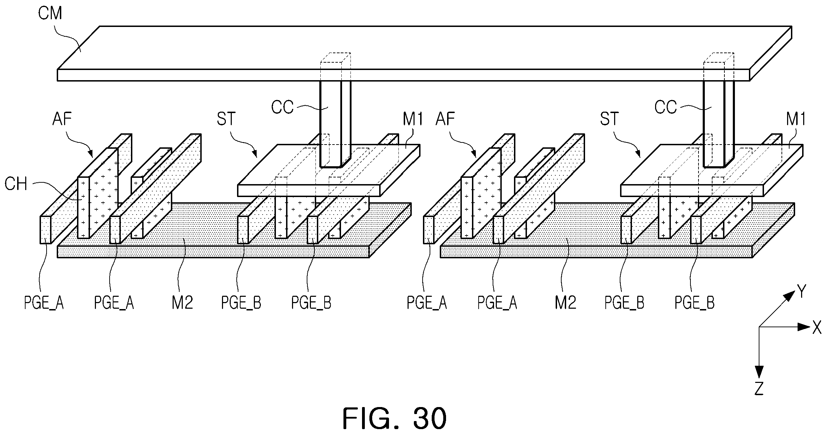

FIG. 30 is a schematic perspective view of a peripheral circuit element of a first peripheral circuit region according to an example embodiment.

Referring to FIG. 30, a first peripheral circuit region PERI1 may include an antifuse array including antifuse memory cells AFC. The antifuse memory cell AFC may include a selection transistor ST and an antifuse AF connected in series. An antifuse gate of the antifuse AF may be electrically connected to the first peripheral gate electrode PGE_A, and a selection gate of the selection transistor ST may be electrically connected to a second peripheral gate electrode PGE_B. The first peripheral gate electrode PGE_A and the second peripheral gate electrode PGE_B may correspond to the programming word line WLP and the read word line WLR illustrated in FIG. 29, respectively.

The antifuse array may further include a lower interconnection M2 connecting the selection transistor ST and the antifuse AF in series. The lower interconnection M2 may be electrically connected to a drain region of a channel structure CH of the selection transistor ST and a drain region of a channel structure CH of the antifuse AF.

The antifuse array may further include an upper interconnection M1, a connection contact CC, and an interconnection line CM. The upper interconnection M1 may be electrically connected to a source region of the channel structure CH of the selection transistor ST. The interconnection line CM may electrically connect the upper interconnections M1 connected to the antifuse memory cells AFC through the connection contacts CC. The upper interconnections M1, the connection contacts CC and the interconnection lines CM may correspond to the bit line BL illustrated in FIG. 29. In an example embodiment, the interconnection line CM may be disposed on the same level as one of the wiring layers 103 illustrated in FIG. 7A.

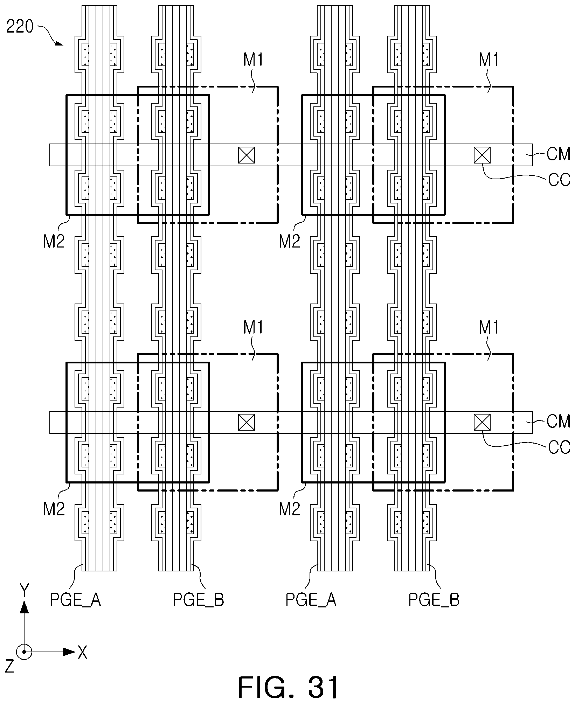

FIG. 31 is a plan view of a peripheral circuit element of a first peripheral circuit region according to an example embodiment.

Referring to FIG. 31, a first peripheral circuit region PERI1 may include an antifuse array including antifuse memory cells AFC. In an example embodiment, an upper interconnection M1 and a lower interconnection M2 of the antifuse array may be electrically connected to a plurality of peripheral channel structures CH spaced apart from each other in the X-direction and the Y-direction. For example, a plurality of peripheral back gate structures 220 may be spaced apart from each other in the X-direction, and the upper interconnection M1 and the lower interconnection M2 may be arranged across the plurality of peripheral back gate structures 220. The peripheral channel structures CH may be disposed on both or opposing sides of each peripheral back gate structure 220, and the plurality of peripheral channel structures CH may be electrically connected to the upper interconnection M1 and the lower interconnection M2. In FIG. 31, eight peripheral channel structures CH are illustrated as being connected to the lower interconnection M2, but the number of peripheral channel structures CH may be variously changed according to an example embodiment.

The present disclosure is not limited to the above-described embodiments and the accompanying drawings but is defined by the appended claims. Therefore, those of ordinary skill in the art may make various replacements, modifications, or changes without departing from the scope of the present disclosure defined by the appended claims, and these replacements, modifications, or changes should be construed as being included in the scope of the present disclosure.

Embodiments are set out in the following clauses:
Clause 1. A semiconductor device, comprising:
   a memory cell array region including memory cells, each of the memory cells including a cell transistor and an information storage structure; and
   a peripheral circuit region spaced apart from the memory cell array region in a horizontal direction,
   wherein the peripheral circuit region includes:
      an upper interconnection disposed on a first vertical level;
      a lower interconnection disposed on a second vertical level, different from the first vertical level; and
      at least one peripheral transistor between the first vertical level and the second vertical level,
      wherein the at least one peripheral transistor includes a channel structure extending in a vertical direction.
Clause 2. The semiconductor device of clause 1,
   wherein the channel structure of the at least one peripheral transistor includes a channel region extending in the vertical direction and a first source/drain region and a second source/drain region disposed in both ends of the channel region and overlapping the channel region in the vertical direction.
Clause 3. The semiconductor device of clause 2,
   wherein the upper interconnection is electrically connected to one of the first source/drain regions of the at least one peripheral transistor, and
   the lower interconnection is electrically connected to one of the second source/drain regions of the at least one peripheral transistor.
Clause 4. The semiconductor device of any of clauses 1 to 3, further comprising:
   a peripheral gate electrode connected to the at least one peripheral transistor,
   wherein the peripheral gate electrode is disposed between the first vertical level and the second vertical level.
Clause 5. The semiconductor device of any of clauses 1 to 4,
   wherein the peripheral circuit region further includes back gate electrodes extending between the at least one peripheral transistor in a horizontal direction.
Clause 6. The semiconductor device of clause 5,
   wherein the channel structure of the at least one peripheral transistor is disposed on both sides of the back gate electrodes.
Clause 7. The semiconductor device of any of clauses 1 to 6,
   wherein the semiconductor device includes at least one inverter circuit,
   the at least one peripheral transistor includes PMOS transistors and NMOS transistors included in the at least one inverter circuit,
   the upper interconnection includes a first upper interconnection connected to the PMOS transistors of the at least one inverter circuit and a second upper interconnection connected to the NMOS transistors, and
   the lower interconnection includes first lower interconnections respectively connected to the PMOS transistors of the at least one inverter circuit and second lower interconnections respectively connected to the NMOS transistors.
Clause 8. The semiconductor device of clause 7,
   wherein the at least one inverter circuit further includes an interconnection line electrically connected to the first lower interconnection and the second lower interconnection, and
   the interconnection line is disposed on a third vertical level different from the first vertical level and the second vertical level.
Clause 9. The semiconductor device of clause 8,
   wherein the first vertical level is between the second vertical level and the third vertical level.
Clause 10. The semiconductor device of clause 8,
   wherein the second vertical level is between the first vertical level and the third vertical level.
Clause 11. The semiconductor device of of any of clauses 8 to 10,
   wherein the at least one inverter circuit is electrically connected to each other through the interconnection line.
Clause 12. The semiconductor device of any of clauses 8 to 11,
   wherein the at least one inverter circuit further includes connection contacts disposed between the first lower interconnection and the interconnection line and between the second lower interconnection and the interconnection line.
Clause 13. The semiconductor device of any of clauses 1 to 12,
   wherein the semiconductor device includes an inverter circuit,
   the inverter circuit includes a plurality of PMOS transistors and a plurality of NMOS transistors among the at least one peripheral transistor,
   the plurality of PMOS transistors are spaced apart from each other in a first horizontal direction and a second horizontal direction, intersecting the first horizontal direction,
   the plurality of NMOS transistors are spaced apart from each other in the first horizontal direction and the second horizontal direction, and
   the number of PMOS transistors and the number of NMOS transistors are different from each other.
Clause 14. The semiconductor device of clause 13,
   wherein the number of PMOS transistors is greater than the number of NMOS transistors.
Clause 15. A semiconductor device, comprising:
   a first structure including a memory cell array region and a first peripheral circuit region spaced apart from the memory cell array region in a horizontal direction,
   wherein the memory cell array region includes:
      a bit line structure;
      cell channel structures disposed on the bit line structure and extending in a vertical direction;
      word lines between the channel structures;
      contact patterns disposed on the cell channel structures and electrically connected to the cell channel structures; and
      an information storage structure on the contact patterns, and
      wherein the first peripheral circuit region includes:
         an upper interconnection disposed on a first level;
         a lower interconnection disposed on a second level, different from the first level; and
         at least one first peripheral transistor between the first level and the second level,
         wherein the at least one first peripheral transistor includes a peripheral channel structure extending in the vertical direction, and
         at least a portion of the upper interconnection is disposed on the same level as the bit line structure.
Clause 16. The semiconductor device of clause 15, wherein at least a portion of the lower interconnection is disposed on the same level as the contact patterns.
Clause 17. The semiconductor device of clause 15 or clause 16, wherein the cell channel structure is disposed on the same level as the peripheral channel structure.
Clause 18. The semiconductor device of any of clauses 15 to 17, further comprising:
   a second structure overlapping the first structure in a vertical direction and including a second peripheral circuit region on the substrate,
   wherein the memory cell array region and the first peripheral circuit region are electrically connected to the second peripheral circuit region.
Clause 19. A semiconductor device, comprising:
   a memory cell array region including memory cells, each of the memory cells including a cell transistor and an information storage structure; and
   a peripheral circuit region spaced apart from the memory cell array region in a horizontal direction,
   wherein the peripheral circuit region includes:
      a first upper interconnection extending in a first horizontal direction and disposed on a first doped region;
      a second upper interconnection extending in the first horizontal direction and disposed on a second doped region;
      a first lower interconnection disposed below the first upper interconnection;
      a second lower interconnection disposed below the second upper interconnection;
      a first channel structure extending between the first upper interconnection and the first lower interconnection in a vertical direction;
      a second channel structure extending between the second upper interconnection and the second lower interconnection in a vertical direction;
      a peripheral gate electrode disposed on side surfaces of the first channel structure and the second channel structure and extending in a second horizontal direction, intersecting the first horizontal direction; and
      a interconnection line electrically connected to the first lower interconnection and the second lower interconnection,
      wherein the first upper interconnection and the second upper interconnection are disposed on a first level, the first lower interconnection and the second lower interconnection are disposed on a second level, and the interconnection line is disposed on a third level, different from the first level and the second level.
Clause 20. The semiconductor device of clause 19, further comprising:
   first connection contacts connecting the interconnection line to the first lower interconnection and the second lower interconnection; and
   a second connection contact on the peripheral gate electrode.

## Claims

1. A semiconductor device, comprising:
a memory cell array region including memory cells, each of the memory cells including a cell transistor and an information storage structure; and
a peripheral circuit region spaced apart from the memory cell array region in a horizontal direction,
wherein the peripheral circuit region includes:
an upper interconnection disposed on a first vertical level;
a lower interconnection disposed on a second vertical level, different from the first vertical level; and
at least one peripheral transistor between the first vertical level and the second vertical level,
wherein the at least one peripheral transistor includes a channel structure extending in a vertical direction.

2. The semiconductor device of claim 1,
wherein the channel structure of the at least one peripheral transistor includes a channel region extending in the vertical direction and a first source/drain region and a second source/drain region disposed in opposing ends of the channel region and overlapping the channel region in the vertical direction.

3. The semiconductor device of claim 2,
wherein the upper interconnection is electrically connected to one of the first source/drain regions of the at least one peripheral transistor, and
the lower interconnection is electrically connected to one of the second source/drain regions of the at least one peripheral transistor.

4. The semiconductor device of any of claims 1 to 3, wherein the at least one peripheral transistor further comprises:
a peripheral gate electrode connected to the at least one peripheral transistor,
wherein the peripheral gate electrode is disposed between the first vertical level and the second vertical level.

5. The semiconductor device of any of claims 1 to 4,
wherein the peripheral circuit region further includes one or more back gate electrodes extending between the at least one peripheral transistor in a horizontal direction.

6. The semiconductor device of claim 5,
wherein the channel structure of the at least one peripheral transistor is disposed on opposing sides of at least one back gate electrode of the one or more back gate electrodes.

7. The semiconductor device of any of claims 1 to 6,
wherein the semiconductor device includes at least one inverter circuit,
the at least one peripheral transistor includes one or more PMOS transistors and one or more NMOS transistors included in the at least one inverter circuit,
the upper interconnection includes a first upper interconnection electrically connected to the one or more PMOS transistors of the at least one inverter circuit and a second upper interconnection electrically connected to the one or more NMOS transistors, and
the lower interconnection includes a first lower interconnection respectively electrically connected to the one or more PMOS transistors of the at least one inverter circuit and a second lower interconnection respectively electrically connected to the one or more NMOS transistors.

8. The semiconductor device of claim 7,
wherein the at least one inverter circuit further includes an interconnection line electrically connected to the first lower interconnection and the second lower interconnection, and
the interconnection line is disposed on a third vertical level different from the first vertical level and the second vertical level.

9. The semiconductor device of claim 8,
wherein the first vertical level is between the second vertical level and the third vertical level.

10. The semiconductor device of claim 8,
wherein the second vertical level is between the first vertical level and the third vertical level.

11. The semiconductor device of any of claims 8 to 10,
wherein the at least one inverter circuit comprises a plurality of inverter circuits that are electrically connected to each other through the interconnection line, or through a plurality of interconnection lines.

12. The semiconductor device of any of claims 8 to 11,
wherein the at least one inverter circuit further includes connection contacts disposed between the first lower interconnection and the interconnection line and between the second lower interconnection and the interconnection line.

13. The semiconductor device of any of claims 1 to 12,
wherein the semiconductor device includes an inverter circuit,
wherein the at least one peripheral transistor comprises a plurality of PMOS transistors and a plurality of NMOS transistors of the inverter circuit,
the plurality of PMOS transistors are spaced apart from each other in a first horizontal direction and a second horizontal direction, that intersects the first horizontal direction,
the plurality of NMOS transistors are spaced apart from each other in the first horizontal direction and the second horizontal direction, and
the number of the plurality of PMOS transistors and the number of the plurality of NMOS transistors of the inverter circuit are different from each other.

14. The semiconductor device of claim 13,
wherein the number of the plurality of PMOS transistors of the inverter circuit is greater than the number of the plurality of NMOS transistors of the inverter circuit.

15. The semiconductor device of any of claims 1 to 14,
wherein the memory cell array region includes:
a bit line structure;
cell channel structures disposed on the bit line structure and extending in the vertical direction;
word lines between the cell channel structures;
contact patterns disposed on the cell channel structures and electrically connected to the cell channel structures; and
an information storage structure on the contact patterns, and
wherein at least a portion of the upper interconnection is disposed on the same level as the bit line structure.
